(19) **Europäisches Patentamt European Patent Office Office européen des brevets**

(11) **EP 4 191 852 B1**

(12) **FASCICULE DE BREVET EUROPEEN**

(45) Date de publication et mention de la délivrance du brevet:
**10.09.2025 Bulletin 2025/37**

(21) Numéro de dépôt: **22211344.1**

(22) Date de dépôt: **05.12.2022**

(51) Classification Internationale des Brevets (IPC):
**H02M 1/00** *(2006.01)* **H02M 1/088** *(2006.01)*
**H02M 3/00** *(2006.01)* **H02M 3/335** *(2006.01)*

(52) Classification Coopérative des Brevets (CPC):
**H02M 3/33573; H02M 1/0058; H02M 3/01; H02M 3/33584;** Y02B 70/10

(54) **CONVERTISSEUR D ÉNERGIE ÉLECTRIQUE AVEC ÉLÉMENT(S) PIÉZOÉLECTRIQUE(S) ET CIRCUIT(S) D AIDE À LA COMMUTATION, SYSTÈME ÉLECTRONIQUE DE CONVERSION D ÉNERGIE ÉLECTRIQUE ASSOCIÉ**

STROMWANDLER MIT PIEZOELEKTRISCHEM ELEMENT UND SCHALTHILFSSCHALTUNG(EN), ELEKTRONISCHES STROMWANDLERSYSTEM

ELECTRIC POWER CONVERTER WITH PIEZOELECTRIC ELEMENT(S) AND SWITCHING ASSISTANCE CIRCUIT(S), ASSOCIATED ELECTRIC POWER CONVERSION ELECTRONIC SYSTEM

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **03.12.2021 FR 2112926**

(43) Date de publication de la demande:
**07.06.2023 Bulletin 2023/23**

(73) Titulaire: **Commissariat à l'Energie Atomique et aux Energies Alternatives 75015 Paris (FR)**

(72) Inventeurs:
• **DESPESSE, Ghislain 38054 Grenoble Cedex 9 (FR)**
• **TOUHAMI, Mustapha 38054 Grenoble (FR)**
• **BRETON, Valentin 38054 Grenoble Cedex 9 (FR)**

(74) Mandataire: **Lavoix 2, place d'Estienne d'Orves 75441 Paris Cedex 09 (FR)**

(56) Documents cités:
CN-A- 102 522 492     US-A1- 2013 169 198
US-A1- 2017 012 556

• POLLET BENJAMIN: "Convertisseurs DC-DC piézoélectrique avec stockage provisoire d'énergie sous forme mécanique", 15 November 2019 (2019-11-15), pages 1 - 169, XP055862319, Retrieved from the Internet <URL:https://tel.archives-ouvertes.fr/tel-02415837/document> [retrieved on 20211116]

**Description**

La présente invention concerne un convertisseur d'énergie électrique, comprenant un premier pont de commutation comportant au moins une première branche de commutation, chaque première branche de commutation étant connectée entre deux bornes d'application d'une tension d'entrée et comportant au moins deux premiers interrupteurs connectés en série et reliés entre eux en un premier point milieu ; un deuxième pont de commutation comportant au moins une deuxième branche de commutation, chaque deuxième branche de commutation étant connectée entre deux bornes de fourniture d'une tension de sortie et comportant au moins deux deuxièmes interrupteurs connectés en série et reliés entre eux en un deuxième point milieu ; et au moins un ensemble piézoélectrique, chaque ensemble piézoélectrique comportant au moins un élément piézoélectrique et étant connecté entre un premier point milieu respectif et un deuxième point milieu respectif.

L'invention concerne également un système électronique de conversion d'énergie électrique comprenant un tel convertisseur d'énergie électrique et un dispositif électronique de pilotage dudit convertisseur.

L'invention concerne le domaine des systèmes électroniques de conversion d'énergie électrique, en particulier ceux comportant un élément piézoélectrique, notamment des systèmes de conversion en une énergie électrique continue, c'est-à-dire les systèmes de conversion continu-continu, également appelés systèmes de conversion DC-DC (de l'anglais *Direct Current - Direct Current*), et les systèmes de conversion alternatif-continu, également appelés systèmes de conversion AC-DC (de l'anglais *Alternating Current - Direct Current*).

US 2017/012556 A1 concerne un circuit de conversion de puissance comprenant un onduleur, une unité de transformation piézoélectrique comprenant des transformateurs piézoélectriques connectés en parallèle à une borne de sortie de l'onduleur.

US 2013/169198 A1 décrit un circuit de commande piézoélectrique à commutation de tension nulle comprenant un circuit de commande en demi-pont, un élément piézoélectrique, et au moins un circuit de dérivation.

CN 102 522 492 A décrit un coupleur piézoélectrique et son circuit de puissance. Ils sont principalement utilisés lorsqu'il est nécessaire d'isoler l'entrée et la sortie dans une alimentation à commutation de faible puissance.

On connait des documents FR 3 064 850 B1, FR 3 086 471 A1 et FR 3 086 472 A1, ainsi que du manuscrit de thèse « Convertisseurs DC-DC piézoélectrique avec stockage provisoire d'énergie sous forme mécanique » de Benjamin POLLET, un convertisseur d'énergie électrique du type précité, visible notamment sur les figures 19 et 20 du document FR 3 086 472 A1.

Les interrupteurs des premier et deuxième ponts de commutation sont commandés de façon cyclique, à la fréquence principale d'oscillation de l'élément piézoélectrique autour de son mode de résonance présélectionné avec, entre chaque application d'une tension via la fermeture d'au moins un interrupteur, une phase dans laquelle l'élément piézoélectrique est en circuit ouvert (charge sensiblement constante) via l'ouverture d'au moins un interrupteur. La fermeture de chaque interrupteur s'effectue avantageusement sous une tension approximativement nulle à ses bornes, et dans tous les cas, la fermeture d'un interrupteur n'engendre jamais une variation importante de tension aux bornes du ou des ensembles piézoélectriques (inférieure à 20%, et avantageusement inférieure à 10%, de la tension d'entrée $V_{in}$ ou de la tension de sortie $V_{out}$).

En régime établi, un cycle de commande comporte typiquement six phases distinctes successives, à savoir trois phases à tension sensiblement constante aux bornes de chaque élément piézoélectrique et trois phases à charge sensiblement constante aux bornes dudit élément piézoélectrique, avec une alternance entre phases à tension sensiblement constante et phases à charge sensiblement constante.

Pour le pilotage d'un tel convertisseur d'énergie électrique, une stratégie de régulation consiste typiquement à réguler la tension de sortie pour suivre une consigne souhaitée, tout en assurant une commutation à zéro de tension et une synchronisation avec le courant interne de l'élément piézoélectrique, comme décrit dans le document FR 3 064 850 B1, ou encore dans l'article "Implementation of control strategy for step-down dc-dc converter based on piezoelectric resonator" de Mustapha TOUHAMI et al (EPE '20 ECCE Europe, pp. 1-9).

Toutefois, le pilotage d'un tel convertisseur d'énergie électrique n'est pas toujours optimal.

Le but de l'invention est alors de proposer un convertisseur d'énergie électrique comportant au moins un élément piézoélectrique, avec un pilotage amélioré.

A cet effet, l'invention a pour objet un convertisseur d'énergie électrique, selon la revendication 1.

Avec le convertisseur d'énergie électrique de l'état de la technique, les commutations des interrupteurs des premier et deuxième ponts de commutation qui sont commandés de façon cyclique pour obtenir les phases précitées du cycle de commande induisent une excursion maximale d'une tension totale du ou des ensembles piézoélectriques, notée $V_p$, cette excursion allant de $-V_{in}-V_{out}$ à $+V_{in}+V_{out}$, où $V_{in}$ est la valeur de la tension d'entrée et $V_{out}$ celle de la tension de sortie.

Chaque élément piézoélectrique est modélisé sous forme d'un condensateur et d'une branche résonante connectée en parallèle du condensateur, la capacité dudit condensateur étant appelée capacité parallèle, ou encore capacité bloquée, ou capacité de référence, et notée $C_0$.

Cette excursion de tension consomme une partie d'un courant interne $I_L$ de l'élément piézoélectrique, circulant dans la branche résonante et disponible pour charger/décharger la capacité parallèle $C_0$. Or, d'une part, ce courant interne $I_L$ est limité par le matériau piézoélectrique lui-même, de par son échauffement et son amplitude de déformation limitée. D'autre part, plus le courant interne $I_L$ est élevé, plus les pertes sont élevées, à savoir les pertes mécaniques dans le matériau piézoélectrique proportionnelles au carré $I_L^2$ du courant interne $I_L$ et les pertes de conduction dans les interrupteurs. Par ailleurs, les pertes diélectriques dans le matériau piézoélectrique augmentent avec l'excursion en tension.

Avec le convertisseur d'énergie électrique selon l'invention, le ou chaque circuit d'aide à la commutation permet de limiter cette excursion en tension, en facilitant certaines commutations des interrupteurs des premier et deuxième ponts de commutation, ainsi que cela sera décrit plus en détail par la suite.

De préférence, le ou chaque circuit d'aide à la commutation comporte alors une inductance ou un élément piézoélectrique additionnel, en sus du ou des ensembles piézoélectriques connectés entre les premier et deuxième points milieux respectifs.

Suivant d'autres aspects avantageux de l'invention, le convertisseur d'énergie électrique est selon l'une quelconque des revendications 2 à 10.

L'invention a aussi pour objet un système électronique de conversion d'énergie électrique, selon la revendication 11.

Ces caractéristiques et avantages de l'invention apparaîtront plus clairement à la lecture de la description qui va suivre, donnée uniquement à titre d'exemple non limitatif, et faite en référence aux dessins annexés, sur lesquels :

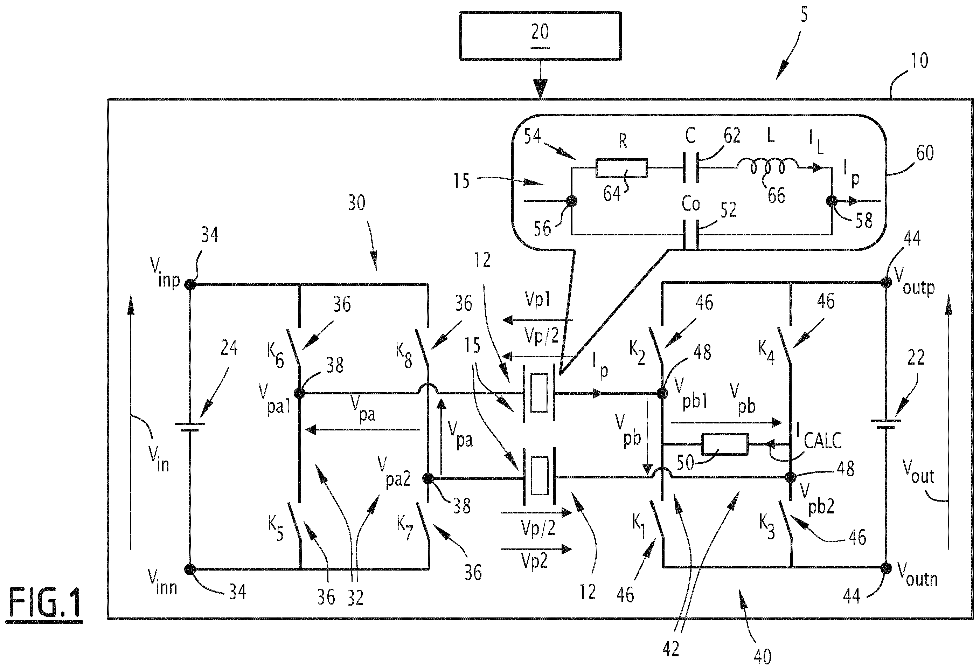

- la figure 1 est une représentation schématique d'un système électronique de conversion d'énergie électrique selon l'invention, comprenant un convertisseur d'énergie électrique et un dispositif électronique de pilotage dudit convertisseur, le convertisseur comportant un premier pont de commutation avec deux premières branches de commutation formées chacune de deux premiers interrupteurs connectés en série et reliés en un premier point milieu, un deuxième pont de commutation avec deux deuxièmes branches de commutation formées chacune de deux deuxièmes interrupteurs connectés en série et reliés en un deuxième point milieu, deux ensembles piézoélectriques connectés entre des premier et deuxième points milieux respectifs, et un circuit d'aide à la commutation connecté entre les premier et deuxième points milieux du deuxième pont, les premier, et respectivement deuxième, ponts étant connectés entre deux bornes d'application d'une tension d'entrée, et respectivement entre deux bornes de fourniture d'une tension de sortie ;
- la figure 2 est une représentation schématique de différents types de circuit d'aide à la commutation ;

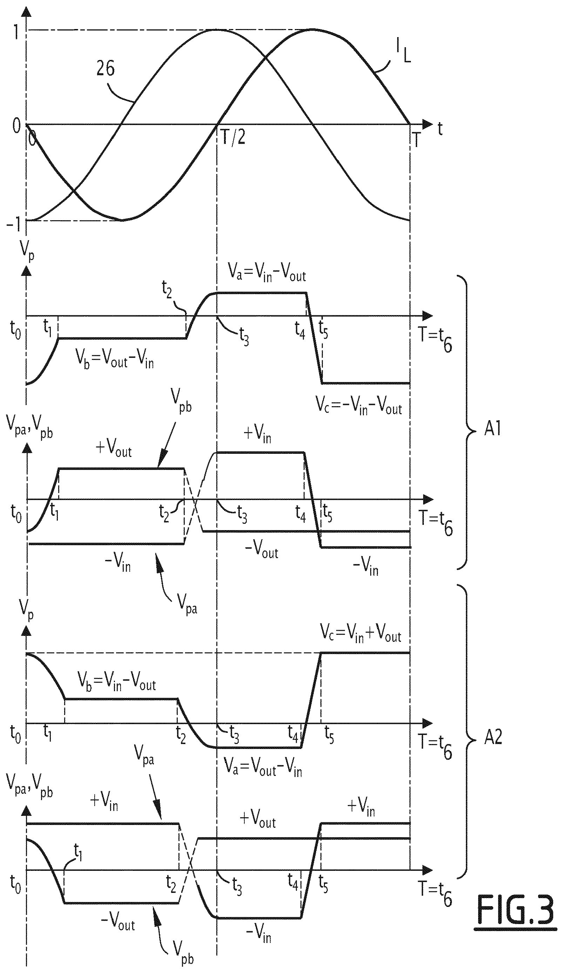

- la figure 3 est un ensemble de courbes représentant un courant circulant dans les ensembles piézoélectriques normalisée à une amplitude de 1, une déformation mécanique totale des ensembles piézoélectriques normalisée à une amplitude de 1, une tension entre des extrémités dudit couple d'ensembles piézoélectriques, une tension entre les autres extrémités dudit couple d'ensembles piézoélectriques, ainsi qu'une tension totale des ensembles piézoélectriques correspondant à la somme desdites tensions élémentaires aux bornes de chaque ensemble piézoélectrique, et ce pour différentes configurations de conversions d'énergie électrique, à savoir pour deux configurations abaisseur de tension ;
- la figure 4 est un ensemble de courbes représentant l'évolution du courant circulant dans le circuit d'aide à la commutation, lorsqu'il est constitué d'une inductance ;
- la figure 5 est une vue analogue à celle de la figure 1, selon un exemple de réalisation où le circuit d'aide à la commutation est constitué d'une inductance et d'une diode connectées en série ;
- la figure 6 est une vue analogue à celle de la figure 1, selon un deuxième mode de réalisation du convertisseur d'énergie électrique, où le circuit d'aide à la commutation est connecté entre les premier et deuxième points milieux du premier pont ;
- la figure 7 est une vue analogue à celle de la figure 3, pour d'autres configurations de conversions d'énergie électrique, à savoir pour deux configurations élévateur de tension, typiquement selon le deuxième mode de réalisation du convertisseur d'énergie électrique ;
- la figure 8 est une vue analogue à celle de la figure 3, selon un exemple de réalisation où la tension d'entrée est sensiblement égale à la tension de sortie ;
- la figure 9 est une vue analogue à celle de la figure 1, selon un troisième mode de réalisation du convertisseur d'énergie électrique, où chacun des premier et deuxième ponts de commutation comporte une seule branche de commutation ; et
- la figure 10 est une vue analogue à celle de la figure 3, pour le troisième mode de réalisation du convertisseur d'énergie électrique.

L'expression « sensiblement égal(e) à » définit une relation d'égalité à plus ou moins 10%, de préférence à plus ou moins 5%.

**EP 4 191 852 B1**

Sur la figure 1, un système électronique de conversion d'énergie électrique 5 comprend un convertisseur d'énergie électrique 10 comportant au moins un ensemble piézoélectrique 12, chaque ensemble piézoélectrique 12 comportant au moins un élément piézoélectrique 15, et plusieurs interrupteurs $K_1$, $K_2$, $K_3$, $K_4$, $K_5$, $K_6$, $K_7$, $K_8$ aptes à être commandés pour alterner des phases à tension sensiblement constante aux bornes du ou des ensembles piézoélectriques 12 et des phases à charge sensiblement constante aux bornes dudit ou desdits ensembles piézoélectriques 12 ; et un dispositif électronique 20 de pilotage du convertisseur d'énergie électrique 10.

Le système électronique de conversion d'énergie électrique 5 est typiquement un système de conversion en une énergie électrique continue, tel qu'un système de conversion continu-continu apte à convertir une première énergie ou tension électrique continue reçue en entrée en une deuxième énergie ou tension électrique continue délivrée en sortie, ou encore un système de conversion alternatif-continu apte à convertir une énergie ou tension électrique alternative reçue en entrée en une énergie ou tension électrique continue délivrée en sortie du système de conversion 5.

Lorsque le système de conversion d'énergie électrique 5 est un système de conversion alternatif-continu, le système de conversion d'énergie électrique 5 comprend de préférence en outre un redresseur de tension, non représenté, connecté en entrée du convertisseur d'énergie électrique 10 et apte à redresser la tension électrique alternative reçue en entrée du système de conversion 5 pour délivrer une tension électrique redressée en entrée du convertisseur 10, le convertisseur d'énergie électrique 10 étant de préférence un convertisseur continu-continu apte à convertir une énergie ou tension électrique continue en une autre énergie ou tension électrique continue. Le redresseur de tension est par exemple un pont redresseur, tel qu'un pont de diodes. En variante, le redresseur de tension est formé en partie par des interrupteurs du convertisseur 10.

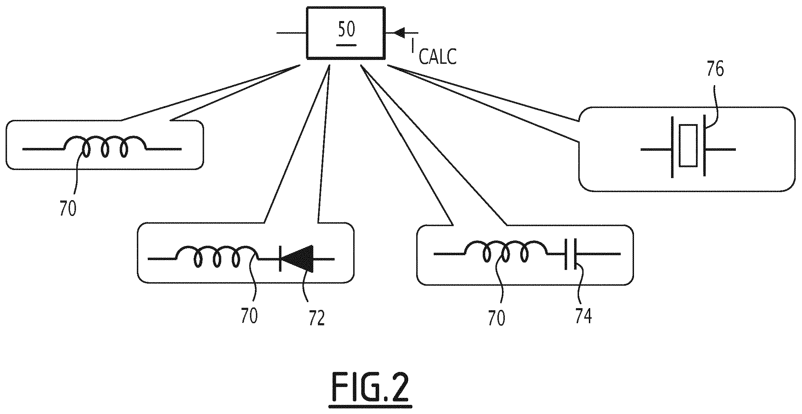

L'homme du métier observera que ces différents exemples pour le système conversion 5, qu'il s'agisse d'un système de conversion continu-continu ou bien d'un système de conversion alternatif-continu, sont également présentés dans les documents FR 3 086 471 A1 et FR 3 086 472 A1, notamment en regard de leurs figures 1 et 2.

Le convertisseur d'énergie électrique 10 est de préférence un convertisseur continu-continu, et est également appelé convertisseur DC-DC. Le convertisseur continu-continu a généralement pour rôle de réguler une tension d'alimentation d'une charge 22 à une valeur stable, en étant alimenté par une source d'énergie 24 fournissant une tension sensiblement continue. La source d'énergie 24 est par exemple une batterie ou un panneau solaire.

Le convertisseur d'énergie électrique 10 est alors configuré pour élever la valeur de la tension continue entre son entrée et sa sortie, et est alors également appelé convertisseur continu-continu élévateur ; ou bien est configuré pour abaisser la valeur de la tension continue entre son entrée et sa sortie, et est alors appelé convertisseur continu-continu abaisseur.

Le convertisseur d'énergie électrique 10 est configuré pour délivrer N tension(s) de sortie distincte(s), à partir de E tension(s) d'entrée distincte(s), E et N étant chacun un nombre entier supérieur ou égal à 1.

Dans l'exemple de la figure 1, le convertisseur d'énergie électrique 10 est configuré pour délivrer une tension de sortie, notée $V_{out}$, à partir d'une tension d'entrée, notée $V_{in}$, le nombre E de tension(s) d'entrée et le nombre N de tension(s) de sortie étant alors chacun égal à 1.

En variante non représentée, le convertisseur d'énergie électrique 10 est configuré pour délivrer plusieurs tensions de sortie distinctes à partir d'une ou plusieurs tensions d'entrée distinctes, le nombre N de tensions de sortie distinctes étant alors supérieur à 1. En variante encore, le convertisseur d'énergie électrique 10 est configuré pour délivrer une ou plusieurs tensions de sortie distincte(s) à partir de plusieurs tensions d'entrée distinctes, le nombre E de tensions d'entrée distinctes étant alors supérieur à 1. En variante encore, le convertisseur d'énergie électrique 10 est configuré pour délivrer plusieurs tensions de sortie distinctes à partir de plusieurs tensions d'entrée distinctes, les nombres E et N étant alors chacun supérieurs à 1.

Lorsque le convertisseur d'énergie électrique 10 est configuré pour délivrer plusieurs tensions de sortie distinctes, le convertisseur 10 est typiquement connecté à plusieurs charges 22, tel que représenté par exemple à la figure 17 du document FR 3 086 471 A1.

De manière analogue, lorsque le convertisseur d'énergie électrique 10 est configuré pour délivrer une ou plusieurs tension(s) de sortie distincte(s) à partir de plusieurs tensions d'entrée distinctes, le convertisseur 10 est alors alimenté par plusieurs sources d'énergie 24.

Le convertisseur d'énergie électrique 10 comporte le ou les ensembles piézoélectriques 12 formés chacun d'un ou plusieurs éléments piézoélectriques 15, et le dispositif de pilotage 20 est configuré pour faire fonctionner le matériau piézoélectrique du ou des éléments piézoélectriques 15 à sa ou leur résonance afin d'exploiter des phases de transfert de charge permettant de s'affranchir de l'utilisation d'un élément inductif, tout en régulant la tension de sortie en conservant la résonance du matériau piézoélectrique, c'est-à-dire avec des cycles de commutation répétés à une fréquence de fonctionnement dépendant de la fréquence de résonance du ou des éléments piézoélectriques 15, et en ajustant les durées de phases de commutation respectives à l'intérieur du cycle de résonance.

En régime établi, le ou les ensembles piézoélectriques 12 échangent une charge et une puissance sensiblement nulle sur un cycle de résonance, aux pertes près. Autrement dit, chaque ensemble piézoélectrique 12 redonne, sensiblement autant qu'il reçoit, d'énergie et de charge sur une période. Deux conditions de fonctionnement s'appliquent alors au régime permanent/établi, à savoir l'équilibre de charge et l'équilibre d'énergie sur une période de résonance. Même si durant les transitoires (démarrage, variation des paliers de tension, changement du courant de sortie) cet équilibre n'est pas respecté, il faut néanmoins qu'il puisse être atteint en régime établi. Ceci impose notamment un certain agencement des paliers de tension durant la période de résonance. Par exemple, pour un fonctionnement à trois paliers de tension, les deux paliers de tension extrêmes sont commandés lors d'une demi-période d'une polarité donnée d'un courant $I_L$ circulant dans les éléments piézoélectriques 15, et le palier de tension intermédiaire est commandé lors de l'autre demi-période de polarité opposée du courant $I_L$ circulant dans les éléments piézoélectriques 15.

Comme connu en soi, l'oscillation mécanique de l'ensemble piézoélectrique 12 est approximativement sinusoïdale, ainsi que représenté sur les figures 3, 7, 8 et 10 par la courbe 26 illustrant la déformation mécanique totale du ou des ensembles piézoélectriques 12 au cours d'un cycle de résonance respectif. Lorsque le convertisseur d'énergie électrique 10 comporte plusieurs ensembles piézoélectriques 12, comme dans les exemples des figures 1, 5 et 6, la déformation mécanique totale des ensembles piézoélectriques 12 est la somme de déformations mécaniques élémentaires de chacun des ensembles piézoélectriques 12.

Une augmentation ou une diminution de l'énergie stockée sur une période conduit respectivement à une augmentation ou à une diminution de l'amplitude d'oscillation. Par ailleurs, lors d'une phase à charge sensiblement constante aux bornes du ou des ensembles piézoélectriques 12, c'est-à-dire lorsque le ou les ensembles piézoélectriques 12 sont placés dans un circuit électrique sensiblement ouvert, avec un faible échange de charges électriques entre le ou les ensembles piézoélectriques 12 et l'extérieur, une augmentation de l'amplitude des oscillations engendre une augmentation de la vitesse de variation de la tension $V_p$ aux bornes du ou des ensembles piézoélectriques 12, et lors d'une phase à tension sensiblement constante aux bornes du ou des ensembles piézoélectriques 12, cette augmentation d'amplitude d'oscillation conduit à une augmentation d'un courant $I_p$ échangé entre le ou les ensembles piézoélectriques 12 et les paliers de tension.

Par charge sensiblement constante, on entend un échange d'une charge avec l'extérieur qui est inférieur à 10% de la charge qui aurait été échangée avec l'extérieur si la tension avait été maintenue constante. Autrement dit, par charge sensiblement constante, on entend une variation de charge inférieure à 10% de la charge qui aurait été échangée avec l'extérieur du ou des ensembles piézoélectriques 12 si la tension aux bornes du ou des ensembles piézoélectriques 12 avait été maintenue constante sur la durée temporelle considérée.

Par circuit électrique sensiblement ouvert, on entend un circuit dont un éventuel courant de fuite conduit à une variation de charge du ou des ensembles piézoélectriques 12 inférieure à 10% de la charge qui aurait été échangée avec l'extérieur du ou des ensembles piézoélectriques 12 si la tension aux bornes du ou des ensembles piézoélectriques 12 avait été maintenue constante sur la durée temporelle considérée.

Par tension sensiblement constante, on entend une variation de tension inférieure à 20%, de préférence inférieure à 10%, de la tension d'entrée ou de sortie du convertisseur 10. À titre d'exemple, si la tension d'entrée du convertisseur 10 est égale à 100V, alors la variation de tension lors de chaque phase à tension sensiblement constante est inférieure à 20% de cette tension, c'est-à-dire inférieure à 20V ; de préférence inférieure à 10 % de cette tension, c'est-à-dire inférieure à 10V. Chaque phase à tension sensiblement constante est également appelée palier de tension.

Le convertisseur 10 comporte alors plusieurs interrupteurs $K_1$, $K_2$, $K_3$, $K_4$, $K_5$, $K_6$, $K_7$, $K_8$ aptes à être commandés pour alterner des phases à tension sensiblement constante et des phases à charge sensiblement constante aux bornes du ou des ensembles piézoélectriques 12, à l'intérieur de périodes de durée sensiblement constante correspondant à la fréquence de fonctionnement du convertisseur 10, dépendant de la fréquence de résonance, également appelée fréquence propre, du ou des ensembles piézoélectriques 12. Les phases à charge sensiblement constante permettent, en régime établi ou permanent, de passer d'une tension constante à une autre et de fermer les interrupteurs qui doivent l'être lorsque la tension à leurs bornes est de préférence nulle afin d'avoir une commutation dite à zéro de tension, également appelée commutation ZVS (de l'anglais *Zero Voltage Switching*). A minima, la fermeture d'un interrupteur ne doit pas aboutir à une variation brutale de la tension $V_p$ (moins de 20%, et de préférence moins de 5%, de la tension d'entrée $V_{in}$ ou de sortie $V_{out}$), qui serait source de pertes significatives, la capacité $C_0$ du piézoélectrique étant significativement supérieure (typiquement au moins 3 fois supérieure) à la capacité parasite des interrupteurs.

En particulier, le convertisseur 10 comprend un premier pont de commutation 30 comportant au moins une première branche de commutation 32, chaque première branche de commutation 32 étant connectée entre deux bornes 34 d'application de la tension d'entrée $V_{in}$ et comportant au moins deux premiers interrupteurs 36 connectés en série et reliés entre eux en un premier point milieu 38. Parmi les deux bornes d'application 34, l'une présente un potentiel inférieur, noté $V_{inn}$, à l'autre, noté $V_{inp}$.

Dans les exemples des figures 1, 5 et 6, le premier pont de commutation 30 comporte deux premières branches de commutation 32 connectées en parallèle entre les deux bornes d'application 34. Dans ces exemples, le premier pont de commutation 30 est de préférence constitué desdites deux premières branches de commutation 32.

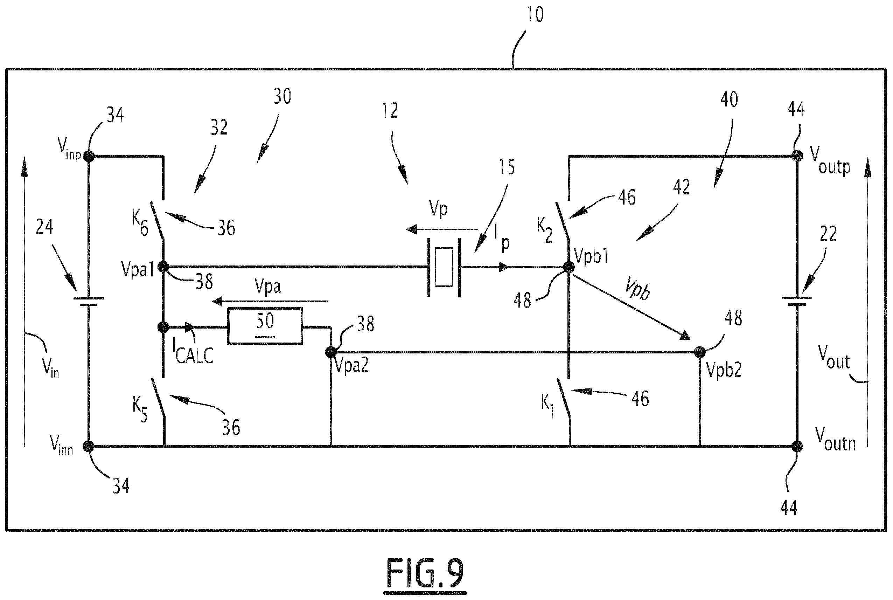

Dans l'exemple de la figure 9, le premier pont de commutation 30 comporte une seule première branche de commutation 32 connectée entre les deux bornes d'application 34. Dans cet exemple, le premier pont de commutation 30 est de préférence constitué de cette unique première branche de commutation 32.

Dans les exemples des figures 1, 5, 6 et 9, chaque première branche de commutation 32 comporte deux premiers interrupteurs 36 connectés en série et reliés en le premier point milieu 38. Chaque première branche de commutation 32 est de préférence constituée des deux premiers interrupteurs 36.

Dans les exemples des figures 1, 5 et 6, avec deux premières branches de commutation 32, les deux premiers interrupteurs 36 sont notés $K_5$, $K_6$ pour l'une des deux premières branches de commutation 32, et respectivement $K_7$, $K_8$ pour l'autre des deux premières branches de commutation 32.

Dans l'exemple de la figure 9, avec une seule première branche de commutation 32, les deux premiers interrupteurs 36 sont notés $K_5$, $K_6$ pour ladite première branche de commutation 32.

Le convertisseur 10 comprend un deuxième pont de commutation 40 comportant au moins une deuxième branche de commutation 42, chaque deuxième branche de commutation 42 étant connectée entre deux bornes 44 de fourniture de la tension de sortie $V_{out}$ et comportant au moins deux deuxièmes interrupteurs 46 connectés en série et reliés entre eux en un deuxième point milieu 48. Parmi les deux bornes de fourniture 44, l'une présente un potentiel inférieur, noté $V_{outn}$, à l'autre, noté $V_{outp}$.

Dans les exemples des figures 1, 5 et 6, le deuxième pont de commutation 40 comporte deux deuxièmes branches de commutation 42 connectées en parallèle entre les deux bornes de fourniture 44. Dans ces exemples, le deuxième pont de commutation 40 est de préférence constitué desdites deux deuxièmes branches de commutation 42.

Dans l'exemple de la figure 9, le deuxième pont de commutation 40 comporte une seule deuxième branche de commutation 42 connectée entre les deux bornes de fourniture 44. Dans cet exemple, le deuxième pont de commutation 40 est de préférence constitué de cette unique deuxième branche de commutation 42.

Dans les exemples des figures 1, 5, 6 et 9, chaque deuxième branche de commutation 42 comporte deux deuxièmes interrupteurs 46 connectés en série et reliés en le deuxième point milieu 48. Chaque deuxième branche de commutation 42 est de préférence constituée des deux deuxièmes interrupteurs 46.

Dans les exemples des figures 1, 5 et 6, avec deux deuxièmes branches de commutation 42, les deux deuxièmes interrupteurs 46 sont notés $K_1$, $K_2$ pour l'une des deux deuxièmes branches de commutation 42, et respectivement $K_3$, $K_4$ pour l'autre des deux deuxièmes branches de commutation 42.

Dans l'exemple de la figure 9, avec une seule deuxième branche de commutation 42, les deux deuxièmes interrupteurs 46 sont notés $K_1$, $K_2$ pour ladite deuxième branche de commutation 42.

Dans les exemples des figures 1, 5 et 6, le convertisseur 10 comprend deux ensembles piézoélectriques 12, chacun étant connecté entre des premier 38 et deuxième 48 points milieux respectifs, les points milieux 38, 48 entre lesquels sont connectés les ensembles piézoélectriques 12 étant distincts d'un ensemble piézoélectrique 12 à l'autre, chaque pont de commutation 30, 40 comportant alors deux branches de commutation 32, 42 respectives.

Dans l'exemple de la figure 9, le convertisseur 10 comprend un ensemble piézoélectrique 12 connecté entre le premier point milieu 38 de l'unique première branche 32 et le deuxième point milieu 48 de l'unique deuxième branche 42.

Selon l'invention, le convertisseur 10 comprend en outre au moins un circuit d'aide à la commutation 50, chaque circuit d'aide à la commutation 50 étant connecté à un point milieu respectif parmi les premier(s) 38 et deuxième(s) 48 points milieux, chaque circuit d'aide à la commutation 50 étant configuré pour, via la circulation d'un courant préalablement reçu, décharger une capacité parasite d'au moins un interrupteur 36, 46 du pont de commutation 30, 40 respectif auquel il est connecté, et respectivement charger au moins une capacité parasite d'un autre interrupteur 36, 46 dudit pont de commutation 30, 40.

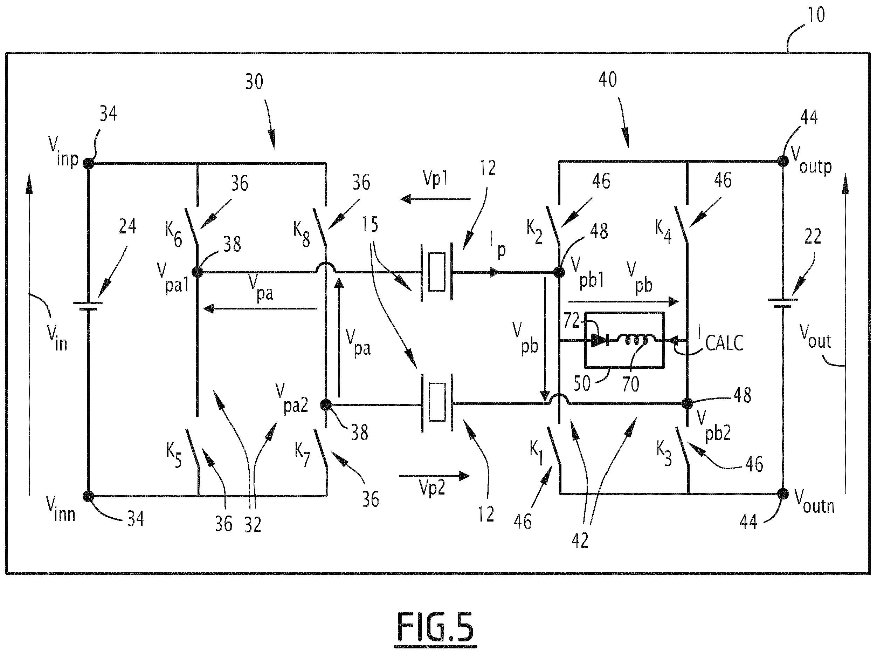

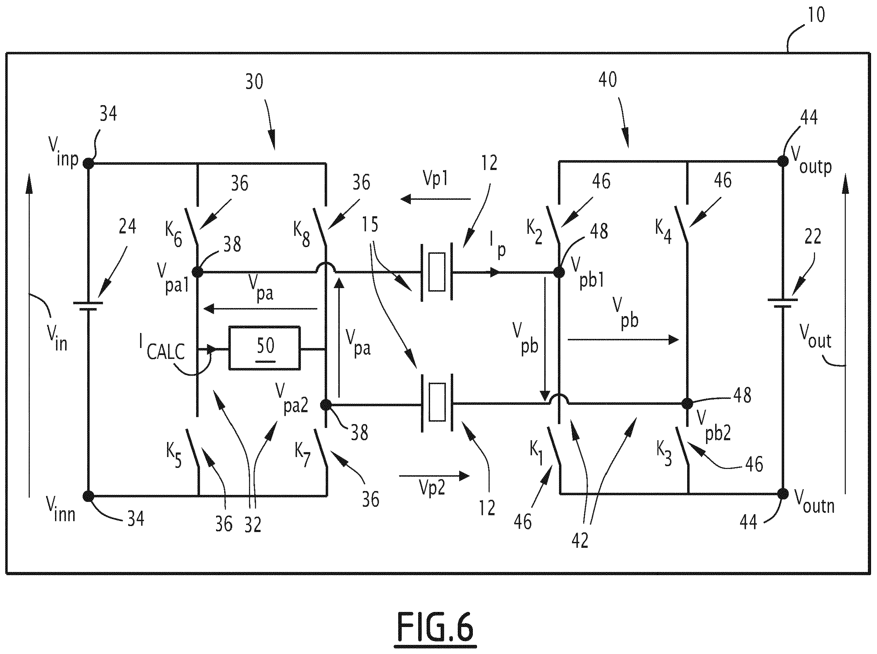

Dans les exemples des figures 1, 5, 6 et 9, le convertisseur 10 comprend un unique circuit d'aide à la commutation 50 connecté au premier pont de commutation 30 ou bien au deuxième pont de commutation 40. Dans les exemples des figures 1 et 5, l'unique circuit d'aide à la commutation 50 est connecté au deuxième pont de commutation 40. Dans les exemples des figures 6 et 9, l'unique circuit d'aide à la commutation 50 est connecté au premier pont de commutation 30.

Dans les exemples des figures 1, 5 et 6, le deuxième pont de commutation 40 comporte deux deuxièmes branches de commutation 42, respectivement le premier pont de commutation 30 comporte deux premières branches de commutation 32 ; et le circuit d'aide à la commutation 50 est alors connecté entre les points milieux respectifs 38, 48 des deux branches de commutation 32, 42 dudit pont 30, 40. Dans les exemples des figures 1 et 5, le circuit d'aide à la commutation 50 est alors connecté entre les deuxièmes points milieux 48 des deux deuxièmes branches de commutation 42 du deuxième pont de commutation 40. De manière analogue, dans l'exemple de la figure 6, le circuit d'aide à la commutation 50 est alors connecté entre les premiers points milieux 38 des deux premières branches de commutation 32 du premier pont de commutation 30.

Dans l'exemple de la figure 9, le premier pont de commutation 30 comporte l'unique première branche de commutation 32, et le circuit d'aide à la commutation 50 est alors connecté entre le premier point milieu 38 de la première branche 32 du premier pont de commutation 30 et une extrémité de ladite première branche 32, cette extrémité étant elle-même connectée à une borne d'application 34 respective.

En variante, non représentée, le convertisseur 10 comprend deux circuits d'aide à la commutation 50, un premier circuit d'aide à la commutation étant connecté au premier pont de commutation 30 et un deuxième circuit d'aide à la commutation étant connecté au deuxième pont de commutation 40.

Selon cette variante, l'homme du métier comprendra que chaque circuit d'aide à la commutation 50 est susceptible d'être connecté entre les points milieux respectifs 38, 48 des deux branches de commutation 32, 42 lorsque le pont 30, 40 auquel il est connecté comporte deux branches de commutation respectives 32, 42 ; ou bien est susceptible d'être connecté entre le point milieu 38, 48 et une extrémité respective de la branche de commutation 32, 42 correspondante lorsque le pont 30, 40 auquel il est connecté comporte une seule branche de commutation 32, 42.

En complément, lorsqu'un circuit d'aide à la commutation 50 respectif décharge une capacité parasite d'au moins un interrupteur 36, 46 du pont de commutation 30, 40 respectif auquel il est connecté, et respectivement charge au moins une capacité parasite d'un autre interrupteur 36, 46 dudit pont de commutation 30, 40, le dispositif de pilotage 20 est de préférence configuré en outre pour commander l'ouverture d'au moins un premier interrupteur 36 et/ou d'au moins un deuxième interrupteur 46 disposé en série dans une boucle incluant ledit circuit d'aide à la commutation 50, le ou les ensembles piézoélectriques 12, certains des premiers interrupteurs 36 du premier pont 30 et certains des deuxièmes interrupteurs 46 du deuxième pont 40. L'ouverture dudit au moins un premier interrupteur 36 et/ou dudit au moins un deuxième interrupteur 46 inclus dans cette boucle permet alors d'éviter que le circuit d'aide à la commutation 50 ne charge ou bien ne décharge de manière significative une capacité de référence $C_0$, décrite ci-après, du ou des éléments piézoélectriques 15 du ou des ensembles piézoélectriques 12 durant cette phase qui est à charge sensiblement constante, et alors de mieux respecter la constance de la charge durant la phase à charge sensiblement constante au cours de laquelle le circuit d'aide à la commutation 50 respectif est activé, i.e. mis en œuvre.

Selon ce complément, lorsque le circuit d'aide à la commutation 50 respectif qui est activé est un circuit d'aide à la commutation connecté au premier pont de commutation 30, le dispositif de pilotage 20 est préférentiellement configuré pour commander l'ouverture d'au moins un deuxième interrupteur 46 disposé en série dans ladite boucle, telle que définie au paragraphe précédent. De manière corollaire, lorsque le circuit d'aide à la commutation 50 respectif qui est activé est un circuit d'aide à la commutation connecté au deuxième pont de commutation 40, le dispositif de pilotage 20 est préférentiellement configuré pour commander l'ouverture d'au moins un premier interrupteur 36 disposé en série dans ladite boucle.

Chaque interrupteur du convertisseur 10, à savoir chacun des premiers 36 et deuxièmes 46 interrupteurs, également notés $K_1$, $K_2$, $K_3$, $K_4$, $K_5$, $K_6$, $K_7$, $K_8$, est de préférence un interrupteur unidirectionnel en courant et unidirectionnel en tension. L'interrupteur $K_1$, $K_2$, $K_3$, $K_4$, $K_5$, $K_6$, $K_7$, $K_8$ comprend par exemple un transistor, ou une diode, ou encore un transistor et une diode en antiparallèle, non représentés. L'interrupteur $K_1$, $K_2$, $K_3$, $K_4$, $K_5$, $K_6$, $K_7$, $K_8$ est de préférence constitué du transistor, ou de la diode, ou encore du transistor et de la diode en antiparallèle En variante, l'interrupteur $K_1$, $K_2$, $K_3$, $K_4$, $K_5$, $K_6$, $K_7$, $K_8$ comprend une association de plusieurs transistors, et est de préférence constitué d'une telle association de plusieurs transistors. En variante encore, l'interrupteur $K_1$, $K_2$, $K_3$, $K_4$, $K_5$, $K_6$, $K_7$, $K_8$ comprend un switch mécanique, tel qu'un micro-switch MEMS (de l'anglais *MicroElectroMechanical System)*.

Le transistor est, par exemple, un transistor à effet de champ à grille isolée, également appelé MOSFET (de l'anglais *Metal Oxide Semiconductor Field Effect Transistor).* En variante, le transistor est un transistor bipolaire ; un transistor bipolaire à grille isolée, également appelé IGBT (de l'anglais *Insulated Gate Bipolar Transistor)* ; un transistor à base de silicium (Si), un transistor à base de GaN (de l'anglais *Gallium Nitride)* ; un transistor à base de carbure de silicium (SiC), ou un transistor à base de diamant, ou encore un thyristor.

Chaque ensemble piézoélectrique 12 est constitué selon l'une des constitutions parmi le groupe consistant en : un unique élément piézoélectrique 15 ; plusieurs éléments piézoélectriques 15 connectés en série ; plusieurs éléments piézoélectriques 15 connectés en parallèle ; un élément piézoélectrique 15 et un condensateur auxiliaire, non représenté, connectés en série ; un élément piézoélectrique 15 et un condensateur auxiliaire connectés en parallèle ; et un agencement de plusieurs branches parallèles, chaque branche comportant un ou plusieurs éléments piézoélectriques 15 connectés en série ou un condensateur auxiliaire.

Le condensateur auxiliaire est typiquement de capacité supérieure, de préférence au moins trois fois supérieure, à la capacité de référence $C_0$ du ou des éléments piézoélectriques 15.

Lorsque le convertisseur 10 comprend deux ensembles piézoélectriques 12, selon un complément facultatif, les deux ensembles piézoélectriques 12 partagent un même matériau piézoélectrique, tout en ayant les électrodes d'un ensemble piézoélectrique 12 distinctes de celles de l'autre ensemble piézoélectrique 12. Selon ce complément facultatif, les paires d'électrodes d'un ensemble piézoélectrique 12, et respectivement celles de l'autre ensemble piézoélectrique 12, couvrent des surfaces de matériau distinctes. En outre, les électrodes d'un ensemble piézoélectrique 12 ne peuvent dans ce cas pas directement induire un champ électrique significatif dans la partie du matériau piézoélectrique appartenant à l'autre ensemble piézoélectrique 12. Selon ce complément facultatif encore, la capacité entre l'une quelconque des électrodes d'un ensemble piézoélectrique 12 et l'une quelconque des électrodes de l'autre ensemble piézoélectrique 12 est négligeable (au moins 10 fois inférieure) devant la capacité de référence $C_0$ de chacun des ensembles piézoélectriques 12, par exemple en n'étant pas directement en regard de part et d'autre du matériau. Cette mise en commun d'un même matériau permet par exemple de faciliter l'implémentation des ensembles piézoélectriques 12 (limitation du nombre de pièce(s), mise en commun des moyens de fixation) ; et aussi de synchroniser la vibration des deux ensembles piézoélectriques 12, sans toutefois qu'il y ait un transfert significatif d'énergie d'un ensemble à l'autre

(<1/10ème de la puissance de sortie).

L'élément piézoélectrique 15 est connu en soi, et est typiquement modélisé, proche du mode de résonnance exploité, sous la forme d'un condensateur 52 et d'une branche résonante 54 connectée en parallèle du condensateur 52, le condensateur 52 et la branche résonante 54 étant connectés entre une première électrode 56 et une deuxième électrode 58 de l'élément piézoélectrique 15, comme illustré sur la modélisation de l'élément piézoélectrique 15 représentée dans une bulle 60 à la figure 1. La branche résonante 54 est typiquement une branche RLC formée d'un condensateur 62, d'une résistance 64 et d'une bobine 66 connectés en série. La capacité du condensateur 52 connecté en parallèle de la branche résonante 54 est appelée capacité parallèle, ou capacité bloquée, ou encore capacité de référence, et notée $C_0$. La tension aux bornes de l'élément piézoélectrique 15 correspond alors typiquement à la tension aux bornes du condensateur 52.

Dans la présente description, une tension dite piézoélectrique totale $V_p$ est par convention la tension aux bornes de l'ensemble piézoélectrique 12 si le convertisseur 10 comporte un seul ensemble piézoélectrique 12 ; ou bien la somme de chacune des tensions aux bornes des ensembles piézoélectriques 12 si le convertisseur 10 comporte plusieurs ensembles piézoélectriques 12. En particulier, lorsque le convertisseur 10 comprend deux ensembles piézoélectriques 12, à savoir un premier ensemble piézoélectrique et un deuxième ensemble piézoélectrique, chacun étant connecté entre un couple respectif de premier 38 et deuxième 48 points milieux, la tension aux bornes du premier ensemble piézoélectrique est notée $V_{p1}$, et celle aux bornes du deuxième ensemble piézoélectrique est notée $V_{p2}$. La tension piézoélectrique totale $V_p$ est alors égale à la somme de ces tensions $V_{p1}$ et $V_{p2}$, soit $V_{p1}+V_{p2}$. Les deux ensembles piézoélectriques 12 sont de préférence identiques, et présentent sensiblement la même tension à leurs bornes à une éventuelle tension d'offset $V_{offset}$ près, de sorte que les tensions $V_{p1}$ et $V_{p2}$ sont égales à $V_p/2+/-V_{offset}$ selon les équations suivantes :

[1]

$$V_p = V_{p1} + V_{p2}$$

[2]

$$V_{p1} = \frac{V_p}{2} + V_{offset} \ \text{ et } V_{p2} = \frac{V_p}{2} - V_{offset}$$

La tension $V_{offset}$ est une composante sensiblement constante à l'échelle d'une période de résonance et impacte peu l'équilibre de charge ou d'énergie sur une période. Cette tension $V_{offset}$ évolue lentement au regard de la fréquence de pilotage, son ondulation est typiquement à une fréquence au moins 10 fois inférieure à la fréquence de pilotage du ou des ensembles piézoélectriques 12. Par ailleurs, lorsque l'on fait la somme des tensions $V_{p1}+V_{p2}$, cette tension d'offset $V_{offset}$ disparait, et on obtient bien la tension piézoélectrique totale $V_p$, telle que décrite dans les différents cycles. En pratique, cette tension d'offset $V_{offset}$ n'impacte pas la loi de pilotage, et autorise des potentiels $V_{inn}$ et $V_{outn}$ complètement indépendants en basse fréquence.

En outre, dans la présente description et comme représenté sur les figures 1, 5, 6 et 9, la tension entre les premiers points milieux 38 est notée $V_{pa}$, et est par convention égale à la différence de potentiels $(V_{pa1} - V_{pa2})$, où $V_{pa1}$ est le potentiel du premier point milieu 38 connecté au premier ensemble piézoélectrique, et $V_{pa2}$ est le potentiel de l'autre premier point milieu 38 connecté au deuxième ensemble piézoélectrique lorsque ce dernier est présent. La tension entre les deuxièmes points milieux 48 est notée $V_{pb}$, et est par convention égale à la différence de potentiels $(V_{pb2} - V_{pb1})$, où $V_{pb1}$ est le potentiel du deuxième point milieu 48 connecté au premier ensemble piézoélectrique, et $V_{pb2}$ est le potentiel de l'autre deuxième point milieu 48 connecté au deuxième ensemble piézoélectrique lorsque ce dernier est présent.

Par convention et comme représenté sur les figures 1, 5 et 6, la tension aux bornes du premier ensemble piézoélectrique $V_{p1}$ est égale à la différence de potentiels $(V_{pa1} - V_{pb1})$, et celle aux bornes du deuxième ensemble piézoélectrique $V_{p2}$ est égale à la différence de potentiels $(V_{pb2} - V_{pa2})$.

La fréquence de résonance est la fréquence à laquelle oscille l'élément piézoélectrique 15 et par conséquent son courant $I_L$, visible sur la figure 1. Le cycle de conversion est synchronisé sur un mouvement mécanique de l'élément piézoélectrique 15, et la fréquence du pilotage est alors calée sur la fréquence d'oscillation mécanique. En pratique, cette fréquence d'oscillation dépend du point de fonctionnement du convertisseur 10 : valeurs des trois paliers de tension et du courant de sortie. En fonction du point de fonctionnement, cette fréquence d'oscillation évolue typiquement entre la fréquence de résonance dite série de l'élément piézoélectrique 15 ($\omega_s=1/\sqrt{(L_r.C_r)}$ où $L_r$ et $C_r$ correspondent aux inductance et capacité de la branche résonante 54 et la fréquence de résonance dite parallèle de l'élément piézoélectrique 15 ($\omega_p=1/\sqrt{(L_r.C_r.C_0/(C_r+C_0))}$), également respectivement appelés fréquence de résonance et fréquence d'antirésonance de l'élément piézoélectrique 15. La fréquence de fonctionnement du convertisseur 10 est alors comprise entre ces deux fréquences de résonance et d'antirésonance de l'élément piézoélectrique 15. Le point de fonctionnement varie lentement au regard de la fréquence d'oscillation de l'élément piézoélectrique 15. Le point de fonctionnement évolue typiquement à moins de 10kHz, alors que la fréquence d'oscillation de l'élément piézoélectrique 15 est typiquement supérieure ou égale à 100kHz. De ce fait, la fréquence de fonctionnement du convertisseur 10 évolue peu d'une période à la suivante.

D'une manière générale, pour le convertisseur d'énergie électrique 10 avec l'ensemble piézoélectrique 12 et piloté par le dispositif électronique de pilotage 20, le nombre de phases à tension sensiblement constante est typiquement d'au moins 2, de préférence égal à 3, tout en pouvant être supérieur ou égal à 4 avec la mise en œuvre du pilotage décrit dans la demande FR 21 07345 déposée le 7 juillet 2021.

Chaque phase à tension sensiblement constante est susceptible d'être obtenue à partir d'une combinaison des tensions d'entrée et/ou de sortie, en valeur positive ou négative, ou encore d'être de tension nulle. Le convertisseur d'énergie 10 permet alors d'échanger de l'énergie entre les phases à tension sensiblement constante, et par voie de conséquence, avec les tensions ou combinaisons de tensions utilisées pour obtenir ces phases à tension sensiblement constante. Il est notamment possible de transférer de l'énergie d'une phase à tension sensiblement constante de faible tension vers une phase à tension sensiblement constante de tension plus élevée, et par le jeu des combinaisons précitées obtenir au final un convertisseur abaisseur de tension, ce qui peut paraître contre-intuitif. Inversement, il est également possible de transférer de l'énergie d'une phase à tension sensiblement constante de tension élevée vers une phase à tension sensiblement constante de tension plus faible, et par le jeu des combinaisons précitées obtenir au final un convertisseur élévateur de tension. L'homme du métier comprendra alors qu'il est possible d'avoir un cycle élévateur vu par l'ensemble piézoélectrique 12 alors que le convertisseur d'énergie électrique 10 est un convertisseur abaisseur, et inversement d'avoir un cycle abaisseur vu par l'ensemble piézoélectrique 12 alors que le convertisseur d'énergie électrique 10 est un convertisseur élévateur.

Par convention, si une puissance est fournie à l'ensemble piézoélectrique 12 lors de la phase à tension sensiblement constante correspondant à la tension la plus élevée au cours d'un cycle de résonance, alors le cycle est considéré comme un cycle abaisseur pour l'ensemble piézoélectrique 12. Inversement, si une puissance est débitée, ou encore tirée, depuis l'ensemble piézoélectrique 12 lors de ladite phase à tension sensiblement constante pour laquelle la tension est la plus élevée au cours du cycle de résonance, alors le cycle est considéré comme un cycle élévateur pour l'ensemble piézoélectrique 12. Comme indiqué précédemment, le cycle de conversion vu par l'ensemble piézoélectrique 12 est susceptible d'être un cycle élévateur alors que le convertisseur d'énergie électrique 10 fonctionne en convertisseur abaisseur, et inversement le cycle de conversion vu par l'ensemble piézoélectrique 12 est susceptible d'être un cycle abaisseur alors que le convertisseur d'énergie électrique 10 fonctionne en convertisseur élévateur.

Le dispositif électronique de pilotage 20 est configuré pour piloter le convertisseur d'énergie électrique 10, en particulier pour piloter la commande des interrupteurs $K_1$, $K_2$, $K_3$, $K_4$, $K_5$, $K_6$, $K_7$, $K_8$ du convertisseur, afin d'alterner des phases à tension sensiblement constante aux bornes de l'ensemble piézoélectrique 12 et des phases à charge sensiblement constante, c'est-à-dire en circuit sensiblement ouvert, aux bornes dudit ensemble piézoélectrique 12.

Le dispositif électronique de pilotage 20 est par exemple réalisé sous forme d'un circuit électronique comportant un ou plusieurs composants électroniques.

En variante, le dispositif électronique de pilotage 20 est réalisé sous forme d'un composant logique programmable, tel qu'un FPGA (de l'anglais *Field Programmable Gate Array*), ou sous forme d'un circuit intégré, tel qu'un ASIC (de l'anglais *Application Specific Integrated Circuit*) ou encore sous forme d'un calculateur, tel qu'un microcontrôleur, un processeur.

Chaque circuit d'aide à la commutation 50 est configuré, via la circulation d'un courant $I_{CALC}$ préalablement reçu, pour décharger au moins une capacité parasite d'un interrupteur 36, 46, de préférence un interrupteur à fermer, du pont de commutation 30, 40 respectif auquel il est connecté ; respectivement pour charger au moins une capacité parasite d'un autre interrupteur 36, 46, de préférence un interrupteur à ouvrir ou à maintenir ouvert, dudit pont de commutation 30, 40.

Chacun des interrupteurs dudit pont de commutation 30 est ouvert lors de la circulation, par le circuit d'aide à la commutation 50, du courant préalablement reçu.

Suite à cette circulation de courant, le/les interrupteur(s) 36, 46 dont la capacité parasite a été déchargée par le circuit d'aide à la commutation 50 est/sont fermés. Le/les autre(s) interrupteur(s) 36, 46 dont la capacité parasite a été chargée par le circuit d'aide à la commutation 50 reste ouvert.

Chaque circuit d'aide à la commutation 50 est dépourvu d'interrupteur commandable, et en particulier chaque circuit d'aide à la commutation 50 est dépourvu de transistor. Autrement dit, chaque circuit d'aide à la commutation 50 ne comporte pas d'interrupteur commandable, chaque circuit d'aide à la commutation 50 ne comporte notamment pas de transistor.

Chaque circuit d'aide à la commutation 50 comporte par exemple une inductance 70 ; ou un premier ensemble formé de l'inductance 70 et d'une diode 72 connectées en série ; ou un deuxième ensemble formé de l'inductance 70 et d'un condensateur 74 connectés en série ; ou encore un élément piézoélectrique additionnel 76, comme représenté sur la figure 2.

Chaque circuit d'aide à la commutation 50 est par exemple une inductance 70, l'inductance 70 étant de préférence constituée d'une bobine et d'un circuit magnétique. En variante, chaque circuit d'aide à la commutation 50 est en forme du premier ensemble de l'inductance 70 et de la diode 72 connectées en série, et de préférence constitué dudit premier ensemble de l'inductance 70 et de la diode 72. En variante encore, chaque circuit d'aide à la commutation 50 est en forme du deuxième ensemble de l'inductance 70 et du condensateur 74 connectés en série, et de préférence constitué dudit deuxième ensemble de l'inductance 70 et du condensateur 74. En variante encore, chaque circuit d'aide à la commutation 50 est en forme de l'élément piézoélectrique additionnel 76, et de préférence constitué de l'élément piézoélectrique additionnel 76.

Le courant $I_{CALC}$ préalablement reçu est obtenu lors d'au moins une phase à tension sensiblement constante, l'au moins une phase à tension sensiblement constante précédant alors la décharge de l'au moins une capacité parasite d'un interrupteur 36, 46, et respectivement la charge de l'au moins une capacité parasite d'un autre interrupteur 36, 46, par le circuit d'aide à la commutation 50 respectif. L'homme du métier comprendra alors que l'obtention du courant $I_{CALC}$ utilisé ensuite pour l'aide à la commutation est obtenu lors d'une ou plusieurs phases à tension sensiblement constante qui précèdent l'aide à la commutation, i.e. sont antérieures à l'aide à la commutation. En effet, comme indiqué précédemment, le courant $I_{CALC}$ est préalablement reçu, c'est-à-dire reçu préalablement à la mise en œuvre de l'aide à la commutation, en particulier pour faciliter la décharge de l'au moins une capacité parasite d'un interrupteur 36, 46, et respectivement la charge de l'au moins une capacité parasite d'un autre interrupteur 36, 46. Différents exemples d'obtention du courant $I_{CALC}$ sont décrits par la suite.

Dans l'exemple de réalisation où le circuit d'aide à la commutation 50 est en forme de l'inductance 70 seule, l'inductance 70 voit son courant croitre sur une demi-période, i.e. lorsque la tension à ses bornes est positive ; puis son courant décroitre sur l'autre demi-période, i.e. lorsque la tension à ses bornes est négative. Cet exemple de réalisation du circuit d'aide à la commutation 50 nécessite de préférence que la tension aux bornes de l'inductance 70 soit de moyenne sensiblement nulle, au risque sinon d'avoir une dérive en courant. Si le circuit d'aide à la commutation 50 est connecté au deuxième pont 40, en particulier entre les deuxièmes points milieux 48, la tension aux bornes de l'inductance 70 est la tension $V_{pb}$. Corollairement, si le circuit d'aide à la commutation 50 est connecté au premier pont 30, en particulier entre les premiers points milieux 38, la tension aux bornes de l'inductance 70 est la tension $V_{pa}$.

La variante où le circuit d'aide à la commutation 50 est en forme de l'inductance 70 et de la diode 72 connectées en série, permet de charger l'inductance 70 uniquement sur une demi-période avec la bonne polarité, en particulier pour des cycles où le courant $I_{CALC}$ est reçu au cours d'une période temporelle avec une seule polarité, par exemple entre les instants temporels $t_2$ et $t_3$ pour les cycles abaisseurs A1 et A2 décrits par la suite (polarité positive du courant $I_{CALC}$ pour le cycle abaisseur A1 entre les instants temporels $t_2$ et $t_3$, polarité négative pour le cycle abaisseur A3 entre ces instants temporels $t_2$ et $t_3$). En particulier, la diode 72 permet alors d'éviter de charger l'inductance 70 avec un courant inverse entre les instants temporels t3 et T. Ce fonctionnement unidirectionnel en courant permet aussi de réduire le courant efficace vu par l'inductance 70 et donc les pertes. Par ailleurs, le circuit d'aide à la commutation 50 selon cette variante n'est pas sensible à la présence d'une composante continue à partir du moment où la composante continue est dans le sens d'un blocage de la diode 72.

La variante où le circuit d'aide à la commutation 50 est en forme de l'inductance 70 et du condensateur 74 connectés en série, permet - par rapport à l'exemple de l'inductance 70 seule - de réduire, voire éliminer une composante continue éventuelle. Néanmoins, le condensateur 74 peut être assez volumineux. En effet, la tension aux bornes du condensateur 74 doit évoluer peu, i.e. dans une faible proportion, par rapport à la tension d'entrée $V_{in}$ ou à la tension de sortie $V_{out}$, par exemple avoir une amplitude inférieure à 50% de la tension d'entrée $V_{in}$ ou de sortie $V_{out}$.

Selon la variante où le circuit d'aide à la commutation 50 est en forme de l'élément piézoélectrique additionnel 76, à partir du moment où le pilotage du convertisseur 10 s'effectue entre la fréquence de résonance et d'antirésonance de l'élément piézoélectrique additionnel 76, ce dernier se met à osciller et à produire un courant $I_{CALC}$ sensiblement en quadrature avec la tension à ses bornes, telle que la tension $V_{pb}$ si l'élément piézoélectrique additionnel 76 est connecté au deuxième pont 40 entre les deuxièmes points milieux 48, ou encore la tension $V_{pa}$ si l'élément piézoélectrique additionnel 76 est connecté au premier pont 30 entre les premiers points milieux 38. Le courant $I_{CALC}$ passe alors par un extrema autour de l'instant temporel t3 pour les cycles abaisseurs A1 et A2, ce qui permet d'assurer la fonction d'inversion de la tension $V_{pb}$ entre les instants temporels $t_2$ et $t_3$ ; ou similairement autour de l'instant temporel $t_0$ pour les cycles élévateurs E1 et E2 décrits par la suite, ce qui permet d'assurer la fonction d'inversion de la tension $V_{pa}$ entre les instants temporels $t_0$ et $t_1$.

L'élément piézoélectrique additionnel 76 est typiquement au moins 3 fois plus petit que le ou les éléments piézoélectriques 15 du convertisseur 10, l'élément piézoélectrique additionnel 76 n'ayant qu'à charger/décharger les capacités parasites des interrupteurs 36, 46. La capacité parasite des interrupteurs 36, 46 est en effet considérée comme étant au moins trois fois inférieure à la capacité de référence $C_0$ du ou des éléments piézoélectriques 15 du convertisseur 10. Cette variante où le circuit d'aide à la commutation 50 est en forme de l'élément piézoélectrique additionnel 76 est insensible à une éventuelle composante continue (quelle que soit sa polarité), et le circuit d'aide à la commutation 50 est apte à être connecté aussi bien au premier pont 30 (tension $V_{pa}$) qu'au deuxième pont 40 (tension $V_{pb}$).

Autrement dit, la capacité de référence de l'élément piézoélectrique additionnel 76 est au moins trois fois inférieure à la capacité de référence $C_0$ de chaque ensemble piézoélectrique 12 connecté entre des premier 38 et deuxième 48 points milieux respectifs.

Le fonctionnement du convertisseur 10 dans l'exemple de la figure 1 va désormais être expliqué selon deux configurations abaisseur de tension, à savoir une première configuration abaisseur A1 et une deuxième configuration abaisseur A2 en regard de la figure 3. La différence résultant du circuit d'aide à la commutation 50 selon l'invention porte sur les évolutions des tensions $V_{pa}$ et $V_{pb}$ entre les instants temporels $t_2$ et $t_3$ dans le cas de ces configurations abaisseur A1, A2, et plus particulièrement sur les zones représentées en trait pointillé sur la figure 3, ceci pour marquer la différence.

Le cycle de conversion du convertisseur 10 selon l'invention est décrit ci-après pour les première A1 et deuxième A2 configurations abaisseur, en se focalisant sur les différences par rapport au cycle de conversion d'un convertisseur de l'état de la technique pour les mêmes configurations abaisseur.

L'homme du métier notera que par configuration très élévateur, on entend typiquement une configuration où le gain, c'est-à-dire le ratio de la tension de sortie $V_{out}$ divisée par la tension d'entrée $V_{in}$, est supérieur à 2, i.e. $V_{out}/V_{in} > 2$. Corollairement, par configuration très abaisseur, on entend typiquement une configuration où le gain, c'est-à-dire le ratio de la tension de sortie $V_{out}$ par la tension d'entrée $V_{in}$, est inférieur à 1/2, i.e. $V_{out}/V_{in} < 1/2$.

De même, par configuration élévateur, on entend typiquement une configuration où ledit gain est compris entre 1 et 2, i.e. $V_{in} < V_{out} < 2V_{in}$. Corollairement, par configuration abaisseur, on entend typiquement une configuration où ledit gain est compris entre 1/2 et 1, i.e. $V_{in}/2 < V_{out} < V_{in}$.

Pour la première configuration abaisseur A1, entre les instants temporels $t_1$ et $t_2$, selon l'exemple de réalisation du circuit d'aide à la commutation 50, l'inductance 70 ou bien l'élément piézoélectrique additionnel 76 voit son courant $I_{CALC}$ augmenter, ceci sous la tension $V_{pb}$ égale à $+ V_{out}$. En l'instant temporel $t_2$, le courant $I_{CALC}$ est positif.

Juste avant l'instant temporel $t_2$, la tension piézoélectrique totale $V_p$ est égale à $- V_{in}+V_{out}$, la tension $V_{pa}$ étant égale à $-V_{in}$, et la tension $V_{pb}$ étant égale à $+V_{out}$ ; et les interrupteurs $K_5$, $K_8$, $K_1$, $K_4$ sont fermés.

En l'instant temporel $t_2$, tous les interrupteurs qui étaient fermés s'ouvrent. Le courant $I_{CALC}$ charge alors les capacités parasites des interrupteurs $K_1$, $K_4$, pendant qu'il décharge les capacités parasites des interrupteurs $K_2$ et $K_3$. De même, au travers des ensembles piézoélectriques 12 dont la tension évolue lentement, le courant $I_{CALC}$ charge partiellement les capacités parasites des interrupteurs $K_5$, $K_8$, pendant qu'il décharge partiellement les capacités parasites des interrupteurs $K_6$, $K_7$. La tension $V_{pb}$ évolue ainsi de $+V_{out}$ à $-V_{out}$, tandis que la tension $V_{pa}$ évolue sensiblement de $-V_{in}$ à $-V_{in}+2V_{out}$ plus l'évolution de la tension piézoélectrique totale $V_p$ depuis l'instant temporel $t_2$.

L'inversion de tension $V_{pb}$ est considérée achevée avant que la tension piézoélectrique totale $V_p$ atteigne le palier $V_a$ suivant. En effet, même si l'amplitude du courant $I_{CALC}$ dans le circuit d'aide à la commutation 50 est bien inférieure à l'amplitude du courant interne $I_L$ des éléments piézoélectriques 15 (par exemple au moins 3 fois inférieure pour limiter sa taille), celui-ci n'a néanmoins qu'à charger/décharger les capacités parasites des interrupteurs 36, 46 considérées bien inférieures à la capacité de référence $C_0$ des éléments piézoélectriques 15 (au moins un facteur 3). Par ailleurs, le courant $I_{CALC}$ dans le circuit d'aide à la commutation 50 se rapproche de sa valeur maximale en l'instant temporel $t_3$, alors que le courant interne $I_L$ se rapproche de 0 en ledit instant temporel $t_3$.

Une fois l'inversion complète de la tension $V_{pb}$ atteinte (passage de $V_{out}$ à $-V_{out}$), alors les interrupteurs $K_2$ et $K_3$ sont fermés de sorte à figer la tension $V_{pb}$ tandis que la tension $V_{pa}$ continue sa progression jusqu'à $V_{in}$ sous l'effet de l'augmentation naturelle de la tension piézoélectrique totale $V_p$.

En l'instant temporel $t_3$, les interrupteurs $K_6$ et $K_7$ sont fermés. Les interrupteurs $K_2$ et $K_3$ sont également fermés si cela n'avait pas été déjà fait avant, i.e. si la tension $V_{pb}$ n'avait pas encore atteint $-V_{out}$.

En complément, si les interrupteurs $K_2$ et $K_3$ comportent une diode inverse intrinsèque ou une diode additionnelle placée en parallèle, leur mise en conduction peut se faire naturellement au regard du signe du courant interne $I_L$ après l'instant temporel $t_3$, ou au regard du courant $I_{CALC}$ résiduel avant l'instant temporel $t_3$.

Le reste du cycle de conversion du convertisseur 10 selon l'invention reste sensiblement inchangé par rapport au cycle de conversion du convertisseur de l'état de la technique.

L'excursion en tension de la tension piézoélectrique totale $V_p$ est ainsi limitée entre les instants temporels $t_2$ et $t_4$, celle-ci allant de $-V_{in}+V_{out}$ à $V_{in}-V_{out}$, au lieu d'aller de $-V_{in}+V_{out}$ à $+V_{in}+V_{out}$ avec le convertisseur de l'état de la technique, soit une excursion de $2V_{in}-2V_{out}$ au lieu de $2V_{in}$, tout en assurant des commutations des interrupteurs 36, 46 à zéro de tension.

Pour la deuxième configuration abaisseur A2, entre les instants temporels $t_1$ et $t_2$, selon l'exemple de réalisation du circuit d'aide à la commutation 50, l'inductance 70 ou bien l'élément piézoélectrique additionnel 76 voit son courant $I_{CALC}$ diminuer, ceci sous la tension $V_{pb}$ égale à $-V_{out}$. En l'instant temporel $t_2$, le courant $I_{CALC}$ est négatif.

Juste avant l'instant temporel $t_2$, la tension piézoélectrique totale $V_p$ est égale à $V_{in}-V_{out}$, la tension $V_{pa}$ étant égale à $V_{in}$, et la tension $V_{pb}$ étant égale à $-V_{out}$ ; et les interrupteurs $K_6$, $K_7$, $K_2$, $K_3$ sont fermés.

En l'instant temporel $t_2$, tous les interrupteurs qui étaient fermés s'ouvrent. Le courant $I_{CALC}$ charge alors les capacités parasites des interrupteurs $K_2$, $K_3$, pendant qu'il décharge les capacités parasites des interrupteurs $K_1$ et $K_4$. De même, au travers des ensembles piézoélectriques 12 dont la tension évolue lentement, le courant $I_{CALC}$ charge partiellement les capacités parasites des interrupteurs $K_6$, $K_7$, pendant qu'il décharge partiellement les capacités parasites des interrupteurs $K_5$, $K_8$. La tension $V_{pb}$ évolue ainsi de $-V_{out}$ à $+V_{out}$, tandis que la tension $V_{pa}$ évolue sensiblement de $+V_{in}$ à $+V_{in}-2V_{out}$ plus l'évolution de la tension piézoélectrique totale $V_p$ depuis l'instant temporel $t_2$.

L'inversion de tension $V_{pb}$ est considérée achevée avant que la tension piézoélectrique totale $V_p$ atteigne le palier $V_a$ suivant. En effet, même si l'amplitude du courant $I_{CALC}$ dans le circuit d'aide à la commutation 50 est bien inférieure à l'amplitude du courant interne $I_L$ des éléments piézoélectriques 15 (par exemple au moins 3 fois inférieure pour limiter sa taille), celui-ci n'a néanmoins qu'à charger/décharger les capacités parasites des interrupteurs 36, 46 considérées bien inférieures à la capacité de référence $C_0$ des éléments piézoélectriques 15 (au moins un facteur 3). Par ailleurs, le courant $I_{CALC}$ dans le circuit d'aide à la commutation 50 se rapproche de sa valeur minimale (son extremum négatif) en l'instant temporel $t_3$, alors que le courant interne $I_L$ se rapproche de 0 en ledit instant temporel $t_3$.

Une fois l'inversion complète de la tension $V_{pb}$ atteinte (passage de $-V_{out}$ à $+V_{out}$), alors les interrupteurs $K_1$ et $K_4$ sont fermés de sorte à figer la tension $V_{pb}$ tandis que la tension $V_{pa}$ continue sa progression jusqu'à $-V_{in}$ sous l'effet de la diminution naturelle de la tension piézoélectrique totale $V_p$.

En l'instant temporel $t_3$, les interrupteurs $K_5$ et $K_8$ sont fermés. Les interrupteurs $K_1$ et $K_4$ sont également fermés si cela n'avait pas été déjà fait avant, i.e. si la tension $V_{pb}$ n'avait pas encore atteint $+V_{out}$.

En complément, si les interrupteurs $K_1$ et $K_4$ comportent une diode inverse intrinsèque ou une diode additionnelle placée en parallèle, leur mise en conduction peut se faire naturellement au regard du signe du courant interne $I_L$ après l'instant temporel $t_3$, ou au regard du courant $I_{CALC}$ résiduel avant l'instant temporel $t_3$.

Le reste du cycle de conversion du convertisseur 10 selon l'invention reste sensiblement inchangé par rapport au cycle de conversion du convertisseur de l'état de la technique.

Là encore, l'excursion en tension de la tension piézoélectrique totale $V_p$ est ainsi limitée entre les instants temporels $t_2$ et $t_4$, celle-ci allant de $V_{in}-V_{out}$ à $V_{out}-V_{in}$, au lieu d'aller de $V_{in}-V_{out}$ à $-V_{in}-V_{out}$ avec le convertisseur de l'état de la technique, soit une excursion de $2V_{in}-2V_{out}$ au lieu de $2V_{in}$, tout en assurant des commutations des interrupteurs 36, 46 à zéro de tension.

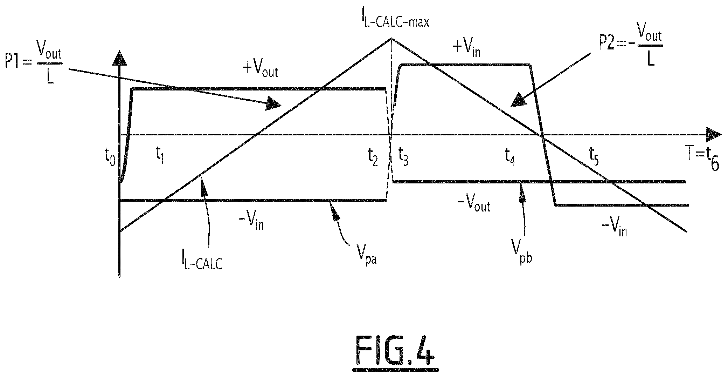

La figure 4 illustre un exemple de dimensionnement de l'inductance 70 du circuit d'aide à la commutation 50.

Durant l'action du circuit d'aide à la commutation 50, les capacités parasites des interrupteurs 36, 46 d'un pont de commutation 30, 40 respectif qui étaient juste avant fermés sont chargées, et les capacités parasites des interrupteurs 36, 46 d'un pont de commutation 30, 40 respectif qui étaient juste avant ouverts sont déchargées. Lorsque le pont de commutation 30, 40 comporte deux branches de commutations 32, 42, les capacités parasites d'une moitié des interrupteurs 36, 46 sont chargées, et les capacités parasites de l'autre moitié des interrupteurs 36, 46 sont déchargées. On note $C_{para\_tot}$ la capacité parasite totale des interrupteurs 36, 46 à charger, celle-ci étant considérée égale à la capacité totale des interrupteurs 36, 46 à décharger, par symétrie des interrupteurs 36, 46.

L'excursion de tension sur ces capacités parasites, liée à l'action du circuit d'aide à la commutation 50, est égale à la tension minimale entre la tension d'entrée $V_{in}$ et la tension de sortie $V_{out}$ lorsque le pont de commutation 30, 40 comporte deux branches de commutations 32, 42. Pour une configuration abaisseur, telle que l'une des première A1 et deuxième A2 configurations abaisseur, l'excursion de tension sur ces capacités parasites est alors égale à la tension de sortie $V_{out}$.

La charge électrique totale que doit apporter le circuit d'aide à la commutation 50, notée $Q_{CALC}$, vérifie alors l'équation suivante :

[3]

$$Q_{CALC} = C_{para\_tot} \cdot Min(V_{in}, V_{out})$$

Pour une configuration abaisseur respective, ladite charge électrique totale $Q_{CALC}$ vérifie alors l'équation suivante :

[4]

$$Q_{CALC} = C_{para\_tot} \cdot V_{out}$$

De manière analogue, pour une configuration élévateur respective, ladite charge électrique totale $Q_{CALC}$ vérifie alors l'équation suivante :

[5]

$$Q_{CALC} = C_{para\_tot} \cdot V_{in}$$

Cette charge $Q_{CALC}$ est idéalement échangée entre les instants temporels $t_2$ et $t_3$ pour les configurations abaisseurs A1 et A2, et un courant d'échange moyen, noté $I_{CALC\_utile}$, vérifie alors l'équation suivante :

[6]

$$I_{CALC\_utile} = \frac{Q_{CALC}}{(t_3 - t_2)} = \frac{C_{para\_tot} \cdot Min(V_{in}, V_{out})}{(t_3 - t_2)}$$

Pour une configuration abaisseur respective, ledit courant d'échange moyen $I_{CALC\_utile}$ vérifie alors l'équation suivante :

[7]

$$I_{CALC\_utile} = \frac{C_{para\_tot} \cdot V_{out}}{(t_3 - t_2)}$$

L'expression du courant dans un circuit d'aide à la commutation 50 constitué de l'inductance 70, noté alors $I_{L-CALC}$, vérifie typiquement l'équation suivante :

[8]

$$I_{L-CALC} = \int \frac{V_{CALC}}{L} dt$$

où $V_{CALC}$ représente la tension aux bornes du circuit d'aide à la commutation 50, i.e. aux bornes de l'inductance 70, et L représente l'inductance de l'inductance 70.

Dans l'exemple de la première configuration abaisseur A1 de la figure 3, en considérant le circuit d'aide à la commutation 50 placé du côté de la tension $V_{pb}$, i.e. connecté au deuxième pont de commutation 40, comme dans l'exemple de la figure 1, la tension $V_{CALC}$ aux bornes du circuit d'aide à la commutation 50, correspondant alors à la tension $V_{pb}$, est sensiblement égale à $+V_{out}$ entre sensiblement les instants temporels $t_0$ et $t_3$ (en considérant les durées de transition de $t_0$ à $t_1$ et de $t_2$ à $t_3$ courtes devant la durée de $t_0$ à $t_3$), et respectivement sensiblement égale à $-V_{out}$ entre les instants temporels $t_3$ et $t_6$.

Quand la tension $V_{CALC}$ aux bornes du circuit d'aide à la commutation 50 est égale à $V_{out}$, le courant $I_{L-CALC}$ dans le circuit d'aide à la commutation 50 augmente en $t*V_{out}/L$, c'est-à-dire selon une première pente P1 égale à $V_{out}/L$. Quand la tension $V_{CALC}$ aux bornes du circuit d'aide à la commutation 50 est égale à $-V_{out}$, le courant $I_{L-CALC}$ dans le circuit d'aide à la commutation 50 décroit en $-t*V_{out}/L$, c'est-à-dire selon une deuxième pente P2 égale à $-V_{out}/L$.

De par la symétrie, le courant $I_{L-CALC}$ dans le circuit d'aide à la commutation 50 passe par zéro à l'instant temporel $T/4$, et sa valeur est maximale autour de l'instant temporel $t_3$ égal à $T/2$ et vaut alors un courant maximal $I_{L-CALC-max}$ égal à $T/4*V_{out}/L$, i.e. égal à $T.V_{out}/(4L)$.

Comme la durée entre les instants temporels $t_2$ et $t_3$ est relativement courte par rapport à la période T du cycle de résonance, le courant $I_{L-CALC}$ est considéré comme relativement constant entre les instants temporels $t_2$ et $t_3$ et proche du courant maximal $I_{L-CALC-max}$.

La valeur de l'inductance L est alors choisie pour que le courant maximal $I_{L-CALC-max}$ se rapproche du courant d'échange moyen $I_{CALC-utile}$ décrit précédemment.

Les courants maximal $I_{L-CALC-max}$ et d'échange moyen $I_{CALC-utile}$ vérifient typiquement l'inéquation suivante :

[9]

$$I_{L-CALC-max} = \frac{T}{4} \cdot \frac{V_{out}}{L} = \frac{T \cdot V_{out}}{4 \cdot L} \geq I_{CALC\_utile}$$

La valeur de l'inductance L vérifie ensuite l'équation suivante :

[10]

$$L \leq \frac{T \cdot V_{out}}{4 \cdot I_{CALC\_utile}}$$

Une valeur maximale $L_{max}$ de l'inductance L, également appelée inductance maximale $L_{max}$, vérifie donc l'équation suivante :

[11]

$$L = \frac{T \cdot V_{out}}{4 \cdot \dfrac{C_{para\_tot} \cdot Min(V_{in}, V_{out})}{(t_3 - t_2)}} = \frac{T \cdot V_{out} \cdot (t_3 - t_2)}{4 \cdot C_{para\_tot} \cdot Min(V_{in}, V_{out})}$$

Pour une configuration abaisseur respective, l'inductance maximale $L_{max}$ vérifie alors l'équation suivante :

[12]

$$L = \frac{T \cdot V_{out}}{4 \cdot \dfrac{C_{para\_tot} \cdot V_{out}}{(t_3 - t_2)}} = \frac{T \cdot (t_3 - t_2)}{4 \cdot C_{para\_tot}}$$

Dans cet exemple, la valeur maximale $L_{max}$ que l'inductance L de l'inductance 70 ne doit pas dépasser se déduit alors de la durée minimale $t_3$-$t_2$ calculée précédemment, tout en notant que plus la valeur de l'inductance L est petite, plus la valeur du courant maximal $I_{L-CALC-max}$ est élevée.

A titre d'exemple de valeurs numériques, avec la capacité parasite totale $C_{para\_tot}$ par exemple égale à 100pF, une fréquence de fonctionnement du convertisseur 10 de 1MHz, soit la période T du cycle de résonance égale à 1µs, et une durée $t_3$-$t_2$ minimale de 50ns, alors l'inductance L doit être inférieure à l'inductance maximale $L_{max}$ égale à 1µs*50ns/(4*100pF), soit 125µH, d'après l'équation (12) précédente.

Dans la variante où le circuit d'aide à la commutation 50 est en forme de l'inductance 70 et de la diode 72 connectées en série, le courant $I_L$ est nul en l'instant temporel $t_0$, et non en l'instant temporel T/2, et il y a donc environ 2 fois plus de temps pour charger l'inductance 70, à savoir la durée T/2 au lieu de la durée T/4, ce qui conduit, pour une même valeur du courant maximal $I_{L-CALC-max}$, à une valeur deux fois plus grande de l'inductance L de l'inductance 70.

L'homme du métier comprendra qu'il s'agit d'ordres de grandeur, qu'une valeur plus faible de l'inductance L fonctionne également, mais qu'elle induit un courant plus grand et donc des pertes plus grandes ; et qu'une valeur plus élevée de l'inductance L conduit à une inversion incomplète de la tension $V_{pb}$ ou respectivement $V_{pa}$, mais reste préférable à une absence totale d'inversion de ladite tension $V_{pb}$ ou $V_{pa}$.

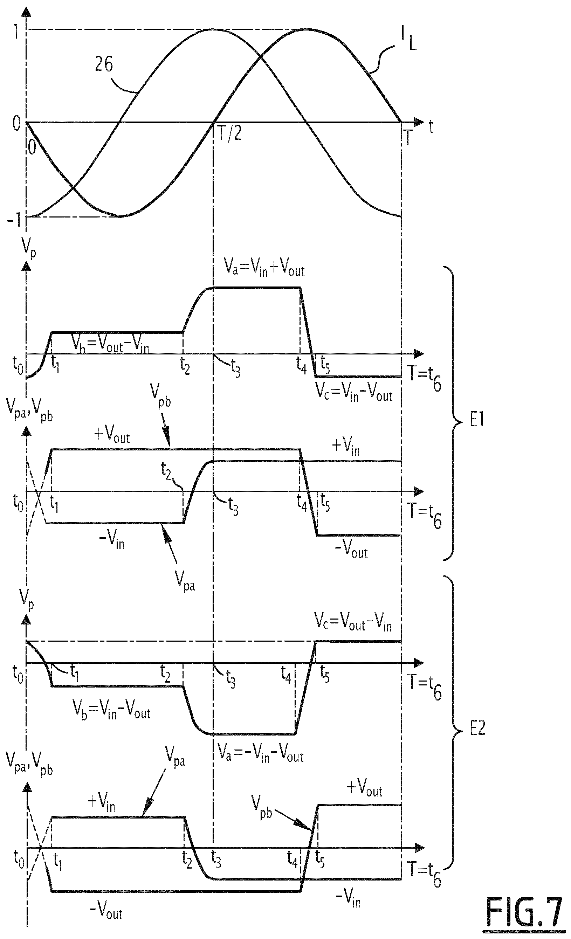

Les figures 6 et 7 illustrent un deuxième mode de réalisation du convertisseur 10 pour lequel le circuit d'aide à la commutation 50 est connecté au premier pont de commutation 30, par exemple entre les premiers points milieux 38 des deux premières branches de commutation 32.

Selon ce deuxième mode de réalisation du convertisseur 10, la différence par rapport au premier mode de réalisation décrit précédemment est que le circuit d'aide à la commutation 50 est alors connecté au premier pont de commutation 30 au lieu d'être connecté au deuxième pont de commutation 40 selon le premier mode de réalisation. Les autres éléments qui sont inchangés entre le premier mode de réalisation et le deuxième mode de réalisation sont repris avec des références identiques.

Le fonctionnement du convertisseur 10 dans l'exemple de la figure 6 va désormais être expliqué selon deux configurations élévateur de tension, à savoir une première configuration élévateur E1 et une deuxième configuration élévateur E2 en regard de la figure 7. La différence résultant du circuit d'aide à la commutation 50 selon l'invention porte sur les évolutions des tensions $V_{pa}$ et $V_{pb}$ entre les instants temporels $t_0$ et $t_1$ dans le cas de ces configurations élévateur E1, E2, et plus particulièrement sur les zones représentées en trait pointillé sur la figure 7, ceci pour marquer la différence.

Le cycle de conversion du convertisseur 10 selon l'invention est décrit ci-après pour les première E1 et deuxième E2 configurations élévateur, en se focalisant sur les différences par rapport au cycle de conversion d'un convertisseur de l'état de la technique pour les mêmes configurations élévateur.

Pour les configurations abaisseur A1 et A2, décrites précédemment, c'était la tension $V_{pb}$ qui avait une polarité homogène sur chacune des deux demi-périodes avec une inversion de polarité entre les deux demi-périodes, et il était alors préférable de disposer le circuit d'aide à la commutation 50 du côté de la tension $V_{pb}$, i.e. connecté au deuxième pont de commutation 40, entre les deuxièmes points milieux 48 respectifs.

Cette fois-ci, pour ces configurations élévateur E1 et E2, c'est la tension $V_{pa}$ qui a une polarité homogène sur chacune des deux demi-périodes avec une inversion de polarité entre les deux demi-périodes (même polarité sur les paliers $V_a$ et $V_c$ et polarité opposée sur le palier $V_b$). Pour ces configurations élévateur E1 et E2, il est donc préférable de disposer le circuit d'aide à la commutation 50 du côté de la tension $V_{pa}$, i.e. connecté au premier pont de commutation 30, entre les premiers points milieux 38 respectifs. Cet agencement du circuit d'aide à la commutation 50 du côté de la tension $V_{pa}$ est préférable sauf dans le cas où le circuit d'aide à la commutation 50 est en forme de l'inductance 70 et de la diode 72 connectées en série, où l'agencement du côté de la tension $V_{pb}$ (i.e. connecté au deuxième pont de commutation 40, entre les deuxièmes points milieux 48 respectifs) reste préférable pour que la composante continue éventuelle ne rende pas la diode 72 passante.

Pour la première configuration élévateur E1, entre les instants temporels $t_3$ et T (ou $t_0$), selon l'exemple de réalisation du circuit d'aide à la commutation 50, l'inductance 70 ou bien l'élément piézoélectrique additionnel 76 voit son courant $I_{CALC}$ augmenter, ceci sous la tension $V_{pa}$ égale à $+V_{in}$. En l'instant temporel T (ou $t_0$), le courant $I_{CALC}$ est positif.

Juste avant l'instant temporel $t_0$, la tension piézoélectrique totale $V_p$ est égale à $V_{in}-V_{out}$, la tension $V_{pa}$ étant égale à $V_{in}$, et la tension $V_{pb}$ étant égale à $-V_{out}$ ; et les interrupteurs $K_6$, $K_7$, $K_2$, $K_3$ sont fermés.

En l'instant temporel $t_0$, tous les interrupteurs qui étaient fermés s'ouvrent. Le courant $I_{CALC}$ charge alors les capacités parasites des interrupteurs $K_6$, $K_7$, pendant qu'il décharge les capacités parasites des interrupteurs $K_5$, $K_8$. De même, au travers des ensembles piézoélectriques 12 dont la tension évolue lentement, le courant $I_{CALC}$ charge partiellement les capacités parasites des interrupteurs $K_2$, $K_3$, pendant qu'il décharge partiellement les capacités parasites des interrupteurs $K_1$, $K_4$. La tension $V_{pa}$ évolue ainsi de $+V_{in}$ à $-V_{in}$, tandis que la tension $V_{pb}$ évolue sensiblement de $-V_{out}$ à $-V_{out}+2V_{in}$ plus l'évolution de la tension piézoélectrique totale $V_p$ depuis l'instant temporel $t_0$.

L'inversion de tension $V_{pa}$ est considérée achevée avant que la tension piézoélectrique totale $V_p$ atteigne le palier $V_b$ suivant. En effet, même si l'amplitude du courant $I_{CALC}$ dans le circuit d'aide à la commutation 50 est bien inférieure à l'amplitude du courant interne $I_L$ des éléments piézoélectriques 15 (par exemple au moins 3 fois inférieure pour limiter sa taille), celui-ci n'a néanmoins qu'à charger/décharger les capacités parasites des interrupteurs 36, 46 considérées bien inférieures à la capacité de référence $C_0$ des éléments piézoélectriques 15 (au moins un facteur 3). Par ailleurs, le courant $I_{CALC}$ dans le circuit d'aide à la commutation 50 se rapproche de sa valeur maximale en l'instant temporel $t_0$, alors que le courant interne $I_L$ se rapproche de 0 en ledit instant temporel $t_0$.

Une fois l'inversion complète de la tension $V_{pa}$ atteinte (passage de $V_{in}$ à $-V_{in}$), alors les interrupteurs $K_5$ et $K_8$ sont fermés de sorte à figer la tension $V_{pa}$ tandis que la tension $V_{pb}$ continue sa progression jusqu'à $V_{out}$ sous l'effet de l'augmentation naturelle de la tension piézoélectrique totale $V_p$.

En l'instant temporel $t_1$, les interrupteurs $K_1$ et $K_4$ sont fermés. Les interrupteurs $K_5$ et $K_8$ sont également fermés si cela n'avait pas été déjà fait avant, i.e. si la tension $V_{pa}$ n'avait pas encore atteint $-V_{in}$.

En complément, si les interrupteurs $K_1$ et $K_4$ comportent une diode inverse intrinsèque ou une diode additionnelle placée en parallèle, leur mise en conduction peut se faire naturellement au regard du signe du courant interne $I_L$ après l'instant temporel $t_0$.

Le reste du cycle de conversion du convertisseur 10 selon l'invention reste sensiblement inchangé par rapport au cycle de conversion du convertisseur de l'état de la technique.

L'excursion en tension de la tension piézoélectrique totale $V_p$ est ainsi limitée entre les instants temporels $t_5$ et $t_1$, celle-ci allant de $V_{in}-V_{out}$ à $V_{out}-V_{in}$, au lieu d'aller de $-V_{in}-V_{out}$ à $V_{out}-V_{in}$ avec le convertisseur de l'état de la technique, soit une excursion de $2V_{out}-2V_{in}$ au lieu de $2V_{out}$, tout en assurant des commutations des interrupteurs 36, 46 à zéro de tension.

Pour la deuxième configuration élévateur E2, entre les instants temporels $t_3$ et T (ou $t_0$), selon l'exemple de réalisation du circuit d'aide à la commutation 50, l'inductance 70 ou bien l'élément piézoélectrique additionnel 76 voit son courant $I_{CALC}$ diminuer, ceci sous la tension $V_{pa}$ égale à $-V_{in}$. En l'instant temporel T (ou $t_0$), le courant $I_{CALC}$ est négatif.

Juste avant l'instant temporel $t_0$, la tension piézoélectrique totale $V_p$ est égale à $-V_{in}+V_{out}$, la tension $V_{pa}$ étant égale à $-V_{in}$, et la tension $V_{pb}$ étant égale à $+V_{out}$ ; et les interrupteurs $K_5$, $K_8$, $K_1$, $K_4$ sont fermés.

En l'instant temporel $t_0$, tous les interrupteurs qui étaient fermés s'ouvrent. Le courant $I_{CALC}$ charge alors les capacités parasites des interrupteurs $K_5$, $K_8$, pendant qu'il décharge les capacités parasites des interrupteurs $K_6$, $K_7$. De même, au travers des ensembles piézoélectriques 12 dont la tension évolue lentement, le courant $I_{CALC}$ charge partiellement les capacités parasites des interrupteurs $K_1$, $K_4$, pendant qu'il décharge partiellement les capacités parasites des interrupteurs $K_2$, $K_3$. La tension $V_{pa}$ évolue ainsi de $-V_{in}$ à $+V_{in}$, tandis que la tension $V_{pb}$ évolue sensiblement de $V_{out}$ à $V_{out}-2V_{in}$ plus l'évolution de la tension piézoélectrique totale $V_p$ depuis l'instant temporel $t_0$.

L'inversion de tension $V_{pa}$ est considérée achevée avant que la tension piézoélectrique totale $V_p$ atteigne le palier $V_b$ suivant. En effet, même si l'amplitude du courant $I_{CALC}$ dans le circuit d'aide à la commutation 50 est bien inférieure à l'amplitude du courant interne $I_L$ des éléments piézoélectriques 15 (par exemple au moins 3 fois inférieure pour limiter sa taille), celui-ci n'a néanmoins qu'à charger/décharger les capacités parasites des interrupteurs 36, 46 considérées bien inférieures à la capacité de référence $C_0$ des éléments piézoélectriques 15 (au moins un facteur 3). Par ailleurs, le courant $I_{CALC}$ dans le circuit d'aide à la commutation 50 se rapproche de sa valeur minimale (son extremum négatif) en l'instant temporel $t_0$, alors que le courant interne $I_L$ se rapproche de 0 en ledit instant temporel $t_0$.

Une fois l'inversion complète de la tension $V_{pa}$ atteinte (passage de $-V_{in}$ à $+V_{in}$), alors les interrupteurs $K_6$ et $K_7$ sont fermés de sorte à figer la tension $V_{pa}$ tandis que la tension $V_{pb}$ continue sa progression jusqu'à $-V_{out}$ sous l'effet de la diminution naturelle de la tension piézoélectrique totale $V_p$.

En l'instant temporel $t_1$, les interrupteurs $K_2$ et $K_3$ sont fermés. Les interrupteurs $K_6$ et $K_7$ sont également fermés si cela n'avait pas été déjà fait avant, i.e. si la tension $V_{pa}$ n'avait pas encore atteint $+V_{in}$.

En complément, si les interrupteurs $K_2$ et $K_3$ comportent une diode inverse intrinsèque ou une diode additionnelle placée en parallèle, leur mise en conduction peut se faire naturellement au regard du signe du courant interne $I_L$ après

**EP 4 191 852 B1**

l'instant temporel $t_0$.

Le reste du cycle de conversion du convertisseur 10 selon l'invention reste sensiblement inchangé par rapport au cycle de conversion du convertisseur de l'état de la technique.

Là aussi, l'excursion en tension de la tension piézoélectrique totale $V_p$ est ainsi limitée entre les instants temporels $t_5$ et $t_1$, celle-ci allant de $V_{out}$-$V_{in}$ à $V_{in}$-$V_{out}$, au lieu d'aller de +$V_{in}$+$V_{out}$ à $V_{in}$-$V_{out}$ avec le convertisseur de l'état de la technique, soit une excursion de $2V_{out}$-$2V_{in}$ au lieu de $2V_{out}$, tout en assurant des commutations des interrupteurs 36, 46 à zéro de tension.

Dans l'exemple de la figure 5, le circuit d'aide à la commutation 50 comporte l'inductance 70 et la diode 72 connectées en série, et la diode 72 est orientée en fonction du sens dans lequel on souhaite faire varier la tension. Par exemple, sur la première configuration abaisseur A1, pour faire passer la tension $V_{pb}$ de +$V_{out}$ à -$V_{out}$, la diode 72 telle que représentée à la figure 5 est dans le mauvais sens. Par exemple encore sur la deuxième configuration abaisseur A2, pour faire passer la tension $V_{pb}$ de -$V_{out}$ à +$V_{out}$, la diode 72 telle que représentée à la figure 5 est dans le bon sens. L'anode de la diode 72 doit être du côté de la borne positive de la tension à modifier et sa cathode du côté de la borne négative de la tension à modifier. Enfin, une fois l'orientation de la diode 72 déterminée, il faut s'assurer que la diode 72 permet bien de bloquer la composante continue éventuelle de la tension, à savoir ici la valeur moyenne de la tension $V_{pb}$, c'est-à-dire vérifier que l'anode est du côté de la borne négative de cette composante continue et que la cathode est du côté de la borne positive de cette composante continue. Dans l'exemple de la figure 5, l'orientation de la diode 72 autorise une composante continue positive pour la tension $V_{pb}$. Si jamais la diode est dans le mauvais sens vis-à-vis de cette composante continue, il faut alors procéder de même sur l'autre pont de commutation, et connecter le circuit d'aide à la commutation 50 à l'autre pont de commutation.

Cet exemple de la figure 5 avec le circuit d'aide à la commutation 50 en forme de l'inductance 70 et de la diode 72 connectées en série, correspond alors au cas où l'agencement du côté de la tension $V_{pb}$ (i.e. connecté au deuxième pont de commutation 40, entre les deuxièmes points milieux 48 respectifs) reste préférable pour que la composante continue positive éventuelle ne rende pas la diode 72 passante (cas des configurations abaisseur A2 ou élévateur E1 ; ou encore cas des configurations abaisseur A1 ou élévateur E2 si on inverse le sens de la diode 72 de la figure 5).

Pour la première configuration élévateur E1, entre les instants temporels $t_0$ et $t_1$, la tension $V_{pb}$ évolue de -$V_{out}$ à +$V_{out}$. Pour y contribuer, le courant $I_{CALC}$ doit être négatif, et la diode 72 est alors disposée dans le sens opposé au sens pris par convention pour le courant $I_{CALC}$. Pour la deuxième configuration élévateur E2, la tension $V_{pb}$ évolue de -$V_{out}$ à +$V_{out}$, et la diode 72 est alors disposée dans l'autre sens.

Pour la première configuration élévateur E1, entre les instants temporels $t_5$ et T (ou $t_0$), selon l'exemple de réalisation du circuit d'aide à la commutation 50, l'inductance 70 ou bien l'élément piézoélectrique additionnel 76 voit son courant $I_{CALC}$ diminuer, ceci sous la tension $V_{pb}$ égale à -$V_{out}$. En l'instant temporel T (ou $t_0$), le courant $I_{CALC}$ est négatif.

Juste avant l'instant temporel $t_0$, la tension piézoélectrique totale $V_p$ est égale à $V_{in}$-$V_{out}$, la tension $V_{pa}$ étant égale à $V_{in}$, et la tension $V_{pb}$ étant égale à -$V_{out}$ ; et les interrupteurs $K_6$, $K_7$, $K_2$, $K_3$ sont fermés.

En l'instant temporel $t_0$, tous les interrupteurs qui étaient fermés s'ouvrent. Le courant $I_{CALC}$ charge alors partiellement les capacités parasites des interrupteurs $K_2$, $K_3$, pendant qu'il décharge partiellement les capacités parasites des interrupteurs $K_1$, $K_4$. De même, au travers des ensembles piézoélectriques 12 dont la tension évolue lentement, le courant $I_{CALC}$ charge les capacités parasites des interrupteurs $K_6$, $K_7$, pendant qu'il décharge les capacités parasites des interrupteurs $K_5$, $K_8$. La tension $V_{pa}$ évolue ainsi de $V_{in}$ à -$V_{in}$, tandis que la tension $V_{pb}$ évolue sensiblement de -$V_{out}$ à -$V_{out}$+$2V_{in}$ plus l'évolution de la tension piézoélectrique totale $V_p$ depuis l'instant temporel $t_0$. La tension $V_{pb}$ ne peut pas être inversée complètement car comme la tension $V_{in}$ est inférieure à la tension $V_{out}$, la tension $V_{pa}$ atteint -$V_{in}$ avant que la tension $V_{pb}$ atteigne +$V_{out}$.

L'inversion de tension $V_{pa}$ est considérée achevée avant que la tension piézoélectrique totale $V_p$ atteigne le palier $V_b$ suivant. En effet, même si l'amplitude du courant $I_{CALC}$ dans le circuit d'aide à la commutation 50 est bien inférieure à l'amplitude du courant interne $I_L$ des éléments piézoélectriques 15 (par exemple au moins 3 fois inférieure pour limiter sa taille), celui-ci n'a néanmoins qu'à charger/décharger les capacités parasites des interrupteurs 36, 46 considérées bien inférieures à la capacité de référence $C_0$ des éléments piézoélectriques 15 (au moins un facteur 3). Par ailleurs, le courant $I_{CALC}$ dans le circuit d'aide à la commutation 50 se rapproche de sa valeur minimale (son extremum négatif) en l'instant temporel $t_0$, alors que le courant interne $I_L$ se rapproche de 0 en ledit instant temporel $t_0$.

Une fois l'inversion complète de la tension $V_{pa}$ atteinte (passage de $V_{in}$ à -$V_{in}$), alors les interrupteurs $K_5$ et $K_8$ sont fermés de sorte à figer la tension $V_{pa}$ tandis que la tension $V_{pb}$ continue sa progression jusqu'à $V_{out}$ sous l'effet de l'augmentation naturelle de la tension piézoélectrique totale $V_p$.

En l'instant temporel $t_1$, les interrupteurs $K_1$ et $K_4$ sont fermés. Les interrupteurs $K_5$ et $K_8$ sont également fermés si cela n'avait pas été déjà fait avant, i.e. si la tension $V_{pa}$ n'avait pas encore atteint -$V_{in}$.

En complément, si les interrupteurs $K_1$ et $K_4$ comportent une diode inverse intrinsèque ou une diode additionnelle placée en parallèle, leur mise en conduction peut se faire naturellement au regard du signe du courant interne $I_L$ après l'instant temporel $t_0$, ou au regard du courant $I_{CALC}$ résiduel avant l'instant temporel $t_0$.

Le reste du cycle de conversion du convertisseur 10 selon l'invention reste sensiblement inchangé par rapport au cycle de conversion du convertisseur de l'état de la technique. En pratique, l'énergie qui reste dans l'inductance 70 est restituée après l'instant temporel $t_1$, sous la tension $V_{out}$ jusqu'à ce que le courant dans l'inductance 70 s'annule et que la diode 72 se bloque.

L'excursion en tension de la tension piézoélectrique totale $V_p$ est ainsi limitée, celle-ci allant de $V_{in}$-$V_{out}$ à $V_{in}$+$V_{out}$, au lieu d'aller de -$V_{in}$-$V_{out}$ à +$V_{in}$+$V_{out}$ avec le convertisseur de l'état de la technique, soit une excursion de $2V_{out}$ au lieu de $2V_{in}$+$2V_{out}$, tout en assurant des commutations des interrupteurs 36, 46 à zéro de tension.

Pour la deuxième configuration élévateur E2, le fonctionnement du convertisseur 10 avec le circuit d'aide à la commutation 50 en forme de l'inductance 70 et de la diode 72 est similaire à celui décrit en regard de la figure 7 pour la deuxième configuration élévateur E2, avec toutefois la diode 72 orientée dans l'autre sens.

En complément facultatif, lorsque le convertisseur 10 comprend deux circuits d'aide à la commutation 50, avec le premier circuit d'aide à la commutation connecté au premier pont de commutation 30 et le deuxième circuit d'aide à la commutation connecté au deuxième pont de commutation 40, les circuits d'aide à la commutation 50 étant alors agencés à la fois du côté de la tension $V_{pa}$ et du côté de la tension $V_{pb}$, les effets des deux circuits d'aide à la commutation 50 s'additionnent. Il faut juste choisir les circuit d'aide à la commutation 50 en fonction de la présence ou non d'une composante continue, et éventuellement selon le signe de cette composante continue s'il y en a une.

En variante, les interrupteurs $K_1$, $K_2$, $K_3$ et $K_4$ sont de simple diodes, et les interrupteurs $K_5$, $K_6$, $K_7$ et $K_8$ sont des interrupteurs monodirectionnels en tension.

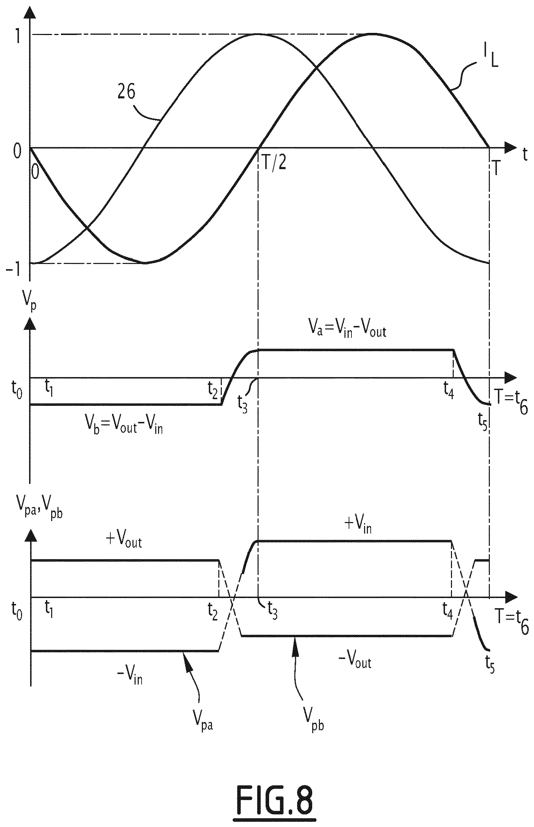

L'exemple de la figure 8 correspond au cas particulier où la tension de sortie $V_{out}$ est sensiblement égale à la tension d'entrée $V_{in}$, le convertisseur 10 servant alors essentiellement à isoler la sortie $V_{out}$ par rapport à l'entrée $V_{in}$, sans changer son amplitude. Dans ce cas, il n'y a plus que deux paliers de tension, à savoir $V_{in}$-$V_{out}$ et $V_{out}$-$V_{in}$. Le principe du circuit d'aide à la commutation 50 s'applique toujours, et le ou les circuits d'aide à la commutation 50 sont alors aptes à être agencés du côté de la tension $V_{pa}$ et/ou du côté de la tension $V_{pb}$, les deux tensions $V_{pa}$ et $V_{pb}$ étant sensiblement symétriques. Autrement dit, dans ce cas, le premier circuit d'aide à la commutation est connecté au premier pont de commutation 30 et/ou le deuxième circuit d'aide à la commutation est connecté au deuxième pont de commutation 40.

En pratique, pour compenser les pertes, la tension d'entrée $V_{in}$ est légèrement supérieure à la tension de sortie $V_{out}$. Pour améliorer la lisibilité de la figure 8, cet écart a été un peu exagéré sur cette figure 8.

Dans l'exemple de la figure 8, la topologie est bidirectionnelle, et l'énergie électrique est également transférable de la sortie vers l'entrée. Dans ce dernier cas, l'écart entre la tension d'entrée $V_{in}$ et la tension de sortie $V_{out}$ sera alors dans l'autre sens. Toutefois, de par la symétrie parfaite du convertisseur 10 dans ce cas, le fonctionnement dans l'autre sens revient simplement à inverser l'entrée et la sortie du convertisseur 10 et à appliquer les enseignements précités.

Dans le cas de la figure 8, le palier $V_c$ a disparu. L'instant temporel $t_5$ est alors confondu avec l'instant temporel $t_6$, et la durée entre les instants temporels $t_4$ et $t_5$ permet d'inverser les polarités des deux tensions $V_{pa}$ et $V_{pb}$. De même, la durée entre les instants temporels $t_2$ et $t_3$ permet d'inverser les polarités des deux tensions $V_{pa}$ et $V_{pb}$. Le ou les circuits d'aide à la commutation 50 permettent alors d'inverser les tensions $V_{pa}$ et $V_{pb}$ sans avoir une excursion de la tension piézoélectrique totale $V_p$ jusqu'à $V_{in}$+$V_{out}$, ou respectivement -$V_{in}$-$V_{out}$.

Le circuit d'aide à la commutation 50 permet alors de limiter drastiquement l'excursion de tension, d'autant plus que la tension de sortie $V_{out}$ est proche de la tension d'entrée $V_{in}$.

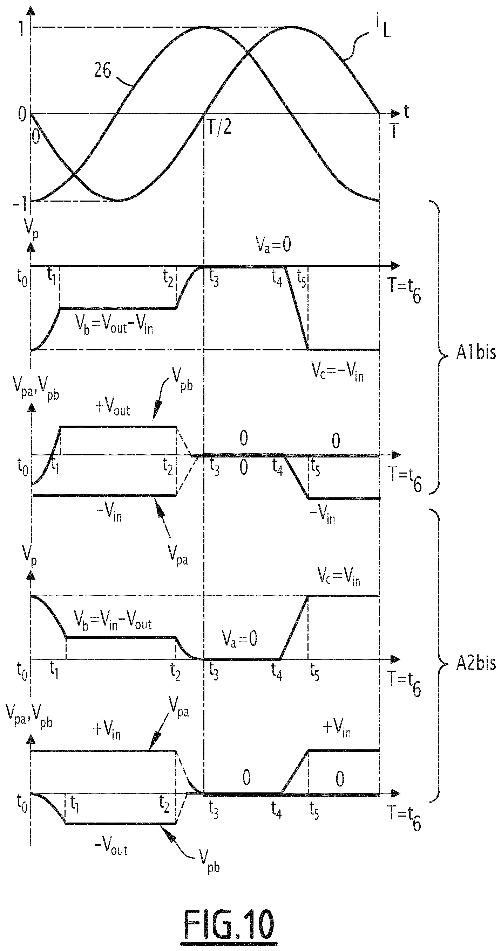

Les figures 9 et 10 illustrent un troisième mode de réalisation du convertisseur 10 pour lequel les premier 30 et deuxième 40 ponts de commutation comportent chacun une seule branche de commutation 32, 42, alors que selon les premier et deuxième modes de réalisation décrits précédemment, les premier 30 et deuxième 40 ponts de commutation comportent chacun deux branches de commutation 32, 42. Selon ce troisième mode de réalisation, le convertisseur 10 comporte un seul ensemble piézoélectrique 12 connecté entre les premier 30 et deuxième 40 ponts de commutation, et la tension piézoélectrique totale $V_p$ est alors la tension aux bornes dudit ensemble piézoélectrique 12.

Dans l'exemple de la figure 9, le circuit d'aide à la commutation 50 est connecté au premier pont de commutation 30, typiquement entre le premier point milieu 38 et l'une des extrémités de l'unique première branche de commutation 32. Dans cet exemple, le circuit d'aide à la commutation 50 est alors placé du côté de la tension $V_{pa}$.

Dans l'exemple de la figure 9, le circuit d'aide à la commutation 50 est en particulier connecté entre le premier point milieu 38 et la borne d'application 34 au potentiel inférieur $V_{inn}$. Il est en outre à noter que les potentiels $V_{pa2}$ et $V_{pb2}$ sont directement connectés l'un à l'autre, et que les potentiels inférieurs $V_{inn}$ et $V_{outn}$ des bornes d'application 34 et de fourniture 44 sont également connectés entre eux.

En variante, non représentée, le circuit d'aide à la commutation 50 est connecté au deuxième pont de commutation 40, typiquement entre le deuxième point milieu 48 et l'une des extrémités de l'unique deuxième branche de commutation 42. Selon cette variante, le circuit d'aide à la commutation 50 est alors placé du côté de la tension $V_{pb}$.

Les autres éléments qui sont inchangés par rapport aux premier et deuxième modes de réalisation décrits précédemment sont repris avec des références identiques.

En complément facultatif, le convertisseur 10 comporte un condensateur auxiliaire, non représenté, connecté entre les premier 30 et deuxième 40 ponts de commutation, typiquement entre un premier point milieu 38 et un deuxième point milieu 48 respectifs, de préférence entre le premier point milieu 38 et le deuxième point milieu 48 auxquels l'ensemble piézoélectrique 12 n'est pas connecté directement. Le condensateur auxiliaire est typiquement de capacité supérieure, de préférence au moins trois fois supérieure, à la capacité de référence $C_0$ du ou des éléments piézoélectriques 15 de l'ensemble piézoélectrique 12.

Selon ce troisième mode de réalisation, le circuit d'aide à la commutation 50 est de préférence en forme de l'élément piézoélectrique additionnel 76 ou en forme de l'inductance 70 et du condensateur 74 connectés en série.

Le fonctionnement du convertisseur 10 dans l'exemple de la figure 9 va désormais être expliqué pour la deuxième configuration abaisseur, notée ici A2bis, en regard de la figure 10. La différence résultant du circuit d'aide à la commutation 50 selon l'invention porte sur les évolutions des tensions $V_{pa}$ et $V_{pb}$ entre les instants temporels $t_2$ et $t_3$, et plus particulièrement sur les zones représentées en trait pointillé sur la figure 10, ceci pour marquer la différence.

Le cycle de conversion du convertisseur 10 selon l'invention est décrit ci-après pour la deuxième configuration abaisseur A2bis, en se focalisant sur les différences par rapport au cycle de conversion d'un convertisseur de l'état de la technique pour la même configuration abaisseur.

Selon ce troisième mode de réalisation, le but n'est pas d'inverser la tension $V_{pa}$ et la tension $V_{pb}$, mais simplement de la faire passer de $V_{in}$ à 0 ou inversement pour la tension $V_{pa}$, et respectivement de 0 à $V_{out}$ ou inversement pour la tension $V_{pb}$.

Pour la deuxième configuration abaisseur A2bis, entre les instants temporels $t_1$ et $t_2$, selon l'exemple de réalisation du circuit d'aide à la commutation 50, l'inductance 70 ou bien l'élément piézoélectrique additionnel 76 voit son courant $I_{CALC}$ augmenter, ceci sous la tension $V_{pa}$ égale à $V_{in}$. En l'instant temporel $t_2$, le courant $I_{CALC}$ est positif.

Juste avant l'instant temporel $t_2$, la tension piézoélectrique totale $V_p$ est égale à $V_{in}-V_{out}$, la tension $V_{pa}$ étant égale à $V_{in}$, et la tension $V_{pb}$ étant égale à $-V_{out}$ ; et les interrupteurs $K_6$, $K_2$ sont fermés.

En l'instant temporel $t_2$, tous les interrupteurs qui étaient fermés s'ouvrent. Le courant $I_{CALC}$ charge alors partiellement la capacité parasite de l'interrupteur $K_6$, pendant qu'il décharge partiellement la capacité parasite de l'interrupteur $K_5$. De même, au travers de l'ensemble piézoélectrique 12 dont la tension évolue lentement, le courant $I_{CALC}$ charge la capacité parasite de l'interrupteur $K_2$, pendant qu'il décharge la capacité parasite de l'interrupteur $K_1$. La tension $V_{pb}$ évolue ainsi de $-V_{out}$ à 0, tandis que la tension $V_{pa}$ évolue sensiblement de $+V_{in}$ à $+V_{in}-V_{out}$ plus l'évolution de la tension piézoélectrique totale $V_p$ depuis l'instant temporel $t_2$.

L'inversion de tension $V_{pb}$ est considérée achevée avant que la tension piézoélectrique totale $V_p$ atteigne le palier $V_a$ suivant. En effet, même si l'amplitude du courant $I_{CALC}$ dans le circuit d'aide à la commutation 50 est bien inférieure à l'amplitude du courant interne $I_L$ de l'ensemble piézoélectrique 12 (par exemple au moins 3 fois inférieure pour limiter sa taille), celui-ci n'a néanmoins qu'à charger/décharger la capacité parasite de l'interrupteur 36, 46 considérée bien inférieure à la capacité de référence $C_0$ de l'ensemble piézoélectrique 12 (au moins un facteur 3). Par ailleurs, le courant $I_{CALC}$ dans le circuit d'aide à la commutation 50 se rapproche de sa valeur maximale en l'instant temporel $t_3$, alors que le courant interne $I_L$ se rapproche de 0 en ledit instant temporel $t_3$.

Une fois l'inversion complète de la tension $V_{pb}$ atteinte (passage de $-V_{out}$ à 0), alors l'interrupteur $K_1$ est fermé de sorte à figer la tension $V_{pb}$ tandis que la tension $V_{pa}$ continue sa progression jusqu'à 0 sous l'effet de la diminution naturelle de la tension piézoélectrique totale $V_p$.

En l'instant temporel $t_3$, l'interrupteur $K_5$ est fermé. L'interrupteur $K_1$ est également fermé si cela n'avait pas été déjà fait avant, i.e. si la tension $V_{pb}$ n'avait pas encore atteint 0.

En complément, si l'interrupteur $K_1$ comporte une diode inverse intrinsèque ou une diode additionnelle placée en parallèle, sa mise en conduction peut se faire naturellement au regard du signe du courant interne $I_L$ après l'instant temporel $t_3$, ou au regard du courant $I_{CALC}$ résiduel avant l'instant temporel $t_3$.

Le reste du cycle de conversion du convertisseur 10 selon l'invention reste sensiblement inchangé par rapport au cycle de conversion du convertisseur de l'état de la technique.

L'homme du métier observera que dans l'exemple des figures 9 et 10, les interrupteurs $K_1$ et $K_2$ peuvent être de simples diodes, qui s'ouvrent et se ferment alors naturellement, c'est-à-dire sans avoir besoin d'être commandées par le dispositif de pilotage 20.

L'homme du métier comprendra que la première configuration abaisseur, notée ici A1bis, de la figure 10, correspond au cas où l'on aurait retiré le premier ensemble piézoélectrique, au lieu du deuxième ensemble piézoélectrique comme dans l'exemple de la figure 9, et que l'on aurait court-circuité les interrupteurs $K_8$, $K_4$ au lieu des interrupteurs $K_7$, $K_3$.

Autrement dit, dans ce cas, le circuit d'aide à la commutation 50 est en particulier connecté entre le premier point milieu 38 et la borne d'application 34 au potentiel supérieur $V_{inp}$. Il est en outre à noter que les potentiels $V_{pa1}$ et $V_{pb1}$ sont directement connectés l'un à l'autre, et que les potentiels supérieurs $V_{inp}$ et $V_{outp}$ des bornes d'application 34 et de fourniture 44 sont également connectés entre eux.

Pour la première configuration abaisseur A1bis, entre les instants temporels $t_1$ et $t_2$, selon l'exemple de réalisation du circuit d'aide à la commutation 50, l'inductance 70 ou bien l'élément piézoélectrique additionnel 76 voit son courant $I_{CALC}$ diminuer, ceci sous la tension $V_{pa}$ égale à $-V_{in}$. En l'instant temporel $t_2$, le courant $I_{CALC}$ est négatif.

Juste avant l'instant temporel $t_2$, la tension piézoélectrique totale $V_p$ est égale à $V_{out}-V_{in}$, la tension $V_{pa}$ étant

égale à -$V_{in}$, et la tension $V_{pb}$ étant égale à $V_{out}$ ; et les interrupteurs $K_5$, $K_1$ sont fermés.

En l'instant temporel $t_2$, tous les interrupteurs qui étaient fermés s'ouvrent. Le courant $I_{CALC}$ charge alors partiellement la capacité parasite de l'interrupteur $K_5$, pendant qu'il décharge partiellement la capacité parasite de l'interrupteur $K_6$. De même, au travers de l'ensemble piézoélectrique 12 dont la tension évolue lentement, le courant $I_{CALC}$ charge la capacité parasite de l'interrupteur $K_1$, pendant qu'il décharge la capacité parasite de l'interrupteur $K_2$. La tension $V_{pb}$ évolue ainsi de +$V_{out}$ à 0, tandis que la tension $V_{pa}$ évolue sensiblement de -$V_{in}$ à -$V_{in}$+$V_{out}$ plus l'évolution de la tension piézoélectrique totale $V_p$ depuis l'instant temporel $t_2$.

La variation de tension $V_{pb}$ est considérée achevée avant que la tension piézoélectrique totale $V_p$ atteigne le palier $V_a$ suivant. En effet, même si l'amplitude du courant $I_{CALC}$ dans le circuit d'aide à la commutation 50 est bien inférieure à l'amplitude du courant interne $I_L$ de l'ensemble piézoélectrique 12 (par exemple au moins 3 fois inférieure pour limiter sa taille), celui-ci n'a néanmoins qu'à charger/décharger la capacité parasite de l'interrupteur 36, 46 considérée bien inférieure à la capacité de référence $C_0$ de l'ensemble piézoélectrique 12 (au moins un facteur 3). Par ailleurs, le courant $I_{CALC}$ dans le circuit d'aide à la commutation 50 se rapproche de sa valeur minimale (son extremum négatif) en l'instant temporel $t_3$, alors que le courant interne $I_L$ se rapproche de 0 en ledit instant temporel $t_3$.

Une fois la variation complète de la tension $V_{pb}$ atteinte (passage de +$V_{out}$ à 0), alors l'interrupteur $K_2$ est fermé de sorte à figer la tension $V_{pb}$ tandis que la tension $V_{pa}$ continue sa progression jusqu'à 0 sous l'effet de l'augmentation naturelle de la tension piézoélectrique totale $V_p$.

En l'instant temporel $t_3$, l'interrupteur $K_6$ est fermé. L'interrupteur $K_2$ est également fermé si cela n'avait pas été déjà fait avant, i.e. si la tension $V_{pb}$ n'avait pas encore atteint 0.

En complément, si l'interrupteur $K_2$ comporte une diode inverse intrinsèque ou une diode additionnelle placée en parallèle, sa mise en conduction peut se faire naturellement au regard du signe du courant interne $I_L$ après l'instant temporel $t_3$, ou au regard du courant $I_{CALC}$ résiduel avant l'instant temporel $t_3$.

Le reste du cycle de conversion du convertisseur 10 selon l'invention reste sensiblement inchangé par rapport au cycle de conversion du convertisseur de l'état de la technique.

On conçoit ainsi que le convertisseur d'énergie électrique 10 selon l'invention offre un pilotage amélioré de par le circuit d'aide à la commutation 50.

En effet, l'au moins un ensemble piézoélectrique 12 a un comportement capacitif qui induit une variation lente de sa tension, i.e. de la tension piézoélectrique totale $V_p$. La recherche du fonctionnement en commutation à zéro de tension, ou commutation ZVS, via l'évolution naturelle de la tension piézoélectrique totale $V_p$ vers des potentiels $V_{in}$+$V_{out}$ et/ou -$V_{in}$-$V_{out}$ a un coût en terme de durée, avec la période temporelle durant laquelle il n'y a pas d'échange de puissance, et aussi un coût en terme de sur-amplitude nécessaire sur le courant $I_L$ pour aller chercher ces points extrêmes de la tension piézoélectrique totale $V_p$.

Le circuit d'aide à la commutation 50 permet alors d'apporter une amélioration significative à ces problèmes du convertisseur d'énergie électrique de l'état de la technique.

## Revendications

1. Convertisseur d'énergie électrique (10), comprenant :

  - un premier pont de commutation (30) comportant au moins une première branche de commutation (32), chaque première branche de commutation (32) étant connectée entre deux bornes (34) d'application d'une tension d'entrée ($V_{in}$) et comportant au moins deux premiers interrupteurs (36) connectés en série et reliés entre eux en un premier point milieu (38) ;
  - un deuxième pont de commutation (40) comportant au moins une deuxième branche de commutation (42), chaque deuxième branche de commutation (42) étant connectée entre deux bornes (44) de fourniture d'une tension de sortie ($V_{out}$) et comportant au moins deux deuxièmes interrupteurs (46) connectés en série et reliés entre eux en un deuxième point milieu (48) ;
  - au moins un ensemble piézoélectrique (12), chaque ensemble piézoélectrique (12) comportant au moins un élément piézoélectrique (15) et étant connecté entre un premier point milieu respectif (38) et un deuxième point milieu respectif (48) ;

    **caractérisé en ce qu'**il comprend en outre au moins un circuit d'aide à la commutation (50), chaque circuit d'aide à la commutation (50) étant connecté à un point milieu respectif parmi les premier(s) (38) et deuxième(s) (48) points milieux, chaque circuit d'aide à la commutation (50) étant configuré pour, via la circulation d'un courant préalablement reçu, décharger au moins une capacité parasite d'un interrupteur (36 ; 46) du pont de commutation respectif (30 ; 40) auquel il est connecté, et respectivement charger au moins une capacité parasite d'un autre interrupteur (36 ; 46) dudit pont de commutation (30 ; 40),

**en ce que** les interrupteurs (36, 46) des premier (30) et deuxième (40) ponts de commutation sont aptes à être commandés pour alterner des phases à tension sensiblement constante aux bornes de chaque ensemble piézoélectrique (12) et des phases à charge sensiblement constante aux bornes de chaque ensemble piézoélectrique (12), la tension sensiblement constante étant une tension avec variation de tension inférieure à 20% de la tension d'entrée ou de sortie du convertisseur (10), la charge sensiblement constante étant une charge avec variation de charge inférieure à 10% de la charge qui aurait été échangée avec l'extérieur du ou des ensembles piézoélectriques (12) si la tension aux bornes du ou des ensembles piézoélectriques (12) avait été maintenue constante sur la durée temporelle considérée, et **en ce que** le courant préalablement reçu est obtenu lors d'au moins une phase à tension sensiblement constante précédant la décharge de l'au moins une capacité parasite d'un interrupteur (36 ; 46), et respectivement la charge de l'au moins une capacité parasite d'un autre interrupteur (36 ; 46), par le circuit d'aide à la commutation (50) respectif.

2. Convertisseur (10) selon la revendication 1, dans lequel le pont de commutation (30 ; 40) auquel est connecté un circuit d'aide à la commutation respectif (50) comporte deux branches de commutation (32 ; 42), et ledit circuit d'aide à la commutation (50) est alors connecté entre les points milieux respectifs (38 ; 48) des deux branches de commutation (32 ; 42) dudit pont (30 ; 40).

3. Convertisseur (10) selon la revendication 2, dans lequel le premier pont de commutation (30) comporte deux premières branches de commutation (32), et le deuxième pont de commutation (40) comporte deux deuxièmes branches de commutation (42) ; et le convertisseur (10) comprend deux ensembles piézoélectriques (12), chacun étant connecté entre des premier (38) et deuxième (48) points milieux respectifs, les points milieux (38, 48) entre lesquels sont connectés les ensembles piézoélectriques (12) étant distincts d'un ensemble piézoélectrique (12) à l'autre.

4. Convertisseur (10) selon la revendication 1, dans lequel le pont de commutation (30, 40) auquel est connecté un circuit d'aide à la commutation respectif (50) comporte une unique branche de commutation (32, 42), et ledit circuit d'aide à la commutation (50) est alors connecté entre le point milieu (38, 48) et une extrémité de ladite branche de commutation (32, 42) dudit pont (30, 40).

5. Convertisseur (10) selon l'une quelconque des revendications précédentes, dans lequel le convertisseur (10) comprend deux circuits d'aide à la commutation (50), un premier circuit d'aide à la commutation étant connecté au premier pont de commutation (30) et un deuxième circuit d'aide à la commutation étant connecté au deuxième pont de commutation (40).

6. Convertisseur (10) selon l'une quelconque des revendications précédentes, dans lequel chaque circuit d'aide à la commutation (50) est dépourvu d'interrupteur commandable, chaque circuit d'aide à la commutation (50) étant notamment dépourvu de transistor.

7. Convertisseur (10) selon l'une quelconque des revendications précédentes, dans lequel chaque circuit d'aide à la commutation (50) comporte un élément choisi parmi le groupe consistant en : une inductance (70) ; un premier ensemble formé d'une inductance (70) et d'une diode (72) connectées en série ; un deuxième ensemble formé d'une inductance (70) et d'un condensateur (74) connectés en série ; et un élément piézoélectrique additionnel (76) ; chaque circuit d'aide à la commutation (50) étant de préférence constitué d'un élément choisi parmi ledit groupe.

8. Convertisseur (10) selon l'une quelconque des revendications précédentes, dans lequel le circuit d'aide à la commutation (50) comporte une inductance (70) et une diode (72) connectées en série, et la diode (72) est orientée en fonction d'un sens de circulation du courant préalablement reçu, la diode (72) étant configurée pour bloquer la circulation d'un courant allant de la polarité positive à la polarité négative d'une éventuelle composante continue en tension dudit courant.

9. Convertisseur (10) selon l'une quelconque des revendications précédentes, dans lequel le circuit d'aide à la commutation (50) comporte un élément piézoélectrique additionnel (76), chaque élément piézoélectrique (15, 76) a une capacité de référence ($C_0$), chaque élément piézoélectrique (15, 76) étant modélisé sous forme d'un condensateur (52) et d'une branche résonante (54) connectée en parallèle du condensateur (52), la capacité de référence ($C_0$) étant la capacité dudit condensateur (52), et dans lequel la capacité de référence de l'élément piézoélectrique additionnel (76) est au moins trois fois inférieure à la capacité de référence ($C_0$) du ou des éléments piézoélectriques (15) de chaque ensemble piézoélectrique (12)

connecté entre des premier (38) et deuxième (48) points milieux respectifs.

10. Convertisseur (10) selon l'une quelconque des revendications précédentes, dans lequel chaque ensemble piézoélectrique (12) est constitué selon l'une des constitutions parmi le groupe consistant en : un unique élément piézoélectrique (15) ; plusieurs éléments piézoélectriques (15) connectés en série ; plusieurs éléments piézoélectriques (15) connectés en parallèle ; un élément piézoélectrique (15) et un condensateur auxiliaire connectés en série ; un élément piézoélectrique (15) et un condensateur auxiliaire connectés en parallèle ; et un agencement de plusieurs branches parallèles, chaque branche comportant un ou plusieurs éléments piézoélectriques (15) connectés en série ou un condensateur auxiliaire ;

le condensateur auxiliaire étant de préférence de capacité supérieure, de préférence encore au moins trois fois supérieure, à une capacité de référence ($C_0$) du ou des éléments piézoélectriques (15), chaque élément piézoélectrique (15) étant modélisé sous forme d'un condensateur (52) et d'une branche résonante (54) connectée en parallèle du condensateur (52), la capacité de référence ($C_0$) étant la capacité dudit condensateur (52).

11. Système électronique de conversion d'énergie électrique (5) comprenant un convertisseur d'énergie électrique (10) et un dispositif électronique (20) de pilotage du convertisseur d'énergie électrique (10),
**caractérisé en ce que** le convertisseur d'énergie électrique (10) est selon l'une quelconque des revendications précédentes.

**Patentansprüche**

1. Stromwandler (10), umfassend:

- eine erste Schaltbrücke (30), die mindestens einen ersten Schaltzweig (32), wobei jeder erste Schaltzweig (32) zwischen zwei Klemmen (34) zum Anlegen einer Eingangsspannung ($V_{in}$) angeschlossen ist, und mindestens zwei erste Schalter (36) aufweist, die in Reihe verbunden und in einem ersten Mittelpunkt (38) miteinander verbunden sind;
- eine zweite Schaltbrücke (40), die mindestens einen zweiten Schaltzweig (42), wobei jeder zweite Schaltzweig (42) zwischen zwei Klemmen (44) zum Bereitstellen einer Ausgangsspannung ($V_{out}$) angeschlossen ist und mindestens zwei zweite Schalter (46) aufweist, die in Reihe verbunden und in einem zweiten Mittelpunkt (48) miteinander verbunden sind;
- mindestens eine piezoelektrische Anordnung (12), wobei jede piezoelektrische Anordnung (12) mindestens ein piezoelektrisches Element (15) aufweist und zwischen einem jeweiligen ersten Mittelpunkt (38) und einem jeweiligen zweiten Mittelpunkt (48) verbunden ist;

**dadurch gekennzeichnet, dass** er ferner mindestens eine Schaltunterstützungsschaltung (50) umfasst, wobei jede Schaltunterstützungsschaltung (50) mit einem jeweiligen des/der ersten (38) und des/der zweiten (48) Mittelpunkte/s verbunden ist, wobei jede Schaltunterstützungsschaltung (50) konfiguriert ist, um über den Fluss eines zuvor empfangenen Stroms mindestens eine Streukapazität eines Schalters (36; 46) der jeweiligen Schaltbrücke (30; 40), mit der er verbunden ist, zu entladen und jeweils mindestens eine Streukapazität eines anderen Schalters (36; 46) der Schaltbrücke (30; 40) zu laden, dass die Schalter (36, 46) der ersten (30) und der zweiten (40) Schaltbrücke geeignet sind, um gesteuert zu werden, um Phasen mit im Wesentlichen konstanter Spannung an jeder piezoelektrischen Anordnung (12) und Phasen mit im Wesentlichen konstanter Ladung an jeder piezoelektrischen Anordnung (12) abzuwechseln, wobei die im Wesentlichen konstante Spannung eine Spannung mit einer Spannungsschwankung von weniger als 20 % der Eingangs- oder Ausgangsspannung des Wandlers (10) ist, wobei die im Wesentlichen konstante Last eine Last mit einer Lastschwankung von weniger als 10 % der Last ist, die mit der Außenseite der piezoelektrischen Anordnung(en) (12) ausgetauscht worden wäre, wenn die Spannung an der/den piezoelektrischen Anordnung(en) (12) über die betrachtete Zeitdauer konstant gehalten worden wäre, und dass der zuvor empfangene Strom in mindestens einer Phase mit im Wesentlichen konstanter Spannung vor der Entladung der mindestens einen parasitären Kapazität eines Schalters (36; 46) bzw. der Ladung der mindestens einen parasitären Kapazität eines anderen Schalters (36; 46) durch die jeweilige Schaltunterstützungsschaltung (50) erlangt wird.

2. Wandler (10) nach Anspruch 1, wobei die Schaltbrücke (30; 40), mit der eine jeweilige Schaltunterstützungsschaltung (50) verbunden ist, zwei Schaltzweige (32; 42) aufweist, und die Schaltunterstützungsschaltung (50) dann zwischen den jeweiligen Mittelpunkten (38; 48) der zwei Schaltzweige (32; 42) der Brücke (30; 40) verbunden ist.

3. Wandler (10) nach Anspruch 2, wobei die erste Schaltbrücke (30) zwei erste Schaltzweige (32) aufweist und die zweite Schaltbrücke (40) zwei zweite Schaltzweige (42) aufweist; und der Wandler (10) zwei piezoelektrische Anordnungen (12) umfasst, die jeweils zwischen entsprechenden ersten (38) und zweiten (48) Mittelpunkten verbunden sind, wobei die Mittelpunkte (38, 48), zwischen denen die piezoelektrischen Anordnungen (12) verbunden sind, von einer piezoelektrischen Anordnung (12) zur anderen verschieden sind.

4. Wandler (10) nach Anspruch 1, wobei die Schaltbrücke (30, 40), mit der eine jeweilige Schaltunterstützungsschaltung (50) verbunden ist, einen einzelnen Schaltzweig (32, 42) aufweist, und die Schaltunterstützungsschaltung (50) dann zwischen dem Mittelpunkt (38, 48) und einem Ende des Schaltzweigs (32, 42) der Brücke (30, 40) verbunden ist.

5. Wandler (10) nach einem der vorherigen Ansprüche, wobei der Wandler (10) zwei Schaltunterstützungsschaltungen (50) umfasst, wobei eine erste Schaltunterstützungsschaltung mit der ersten Schaltbrücke (30) verbunden ist und eine zweite Schaltunterstützungsschaltung mit der zweiten Schaltbrücke (40) verbunden ist.

6. Wandler (10) nach einem der vorherigen Ansprüche, wobei jede Schaltunterstützungsschaltung (50) über keinen steuerbaren Schalter verfügt, wobei jede Schaltunterstützungsschaltung (50) insbesondere über keinen Transistor verfügt.

7. Wandler (10) nach einem der vorherigen Ansprüche, wobei jede Schaltunterstützungsschaltung (50) ein Element aufweist, das ausgewählt ist aus der Gruppe, bestehend aus: einem Induktor (70); einem ersten Satz aus einem Induktor (70) und einer Diode (72), die in Reihe verbunden sind; einem zweiten Satz aus einem Induktor (70) und einem Kondensator (74), die in Reihe verbunden sind; und einem zusätzlichen piezoelektrischen Element (76); wobei jede Schaltunterstützungsschaltung (50) vorzugsweise aus einem Element besteht, das aus der Gruppe ausgewählt ist.

8. Wandler (10) nach einem der vorherigen Ansprüche, wobei die Schaltunterstützungsschaltung (50) ein Induktor (70) und eine Diode (72) umfasst, die in Reihe verbunden sind, und die Diode (72) abhängig von einer Flussrichtung des zuvor empfangenen Stroms ausgerichtet ist, wobei die Diode (72) so konfiguriert ist, um den Fluss eines Stroms zu sperren, der von der positiven Polarität zu der negativen Polarität einer möglichen Gleichspannungs-Komponente des Stroms fließt.

9. Wandler (10) nach einem der vorherigen Ansprüche, wobei die Schaltunterstützungsschaltung (50) ein zusätzliches piezoelektrisches Element (76) aufweist, wobei jedes piezoelektrische Element (15, 76) eine Referenzkapazität ($C_0$) aufweist, jedes piezoelektrische Element (15, 76) als ein Kondensator (52) und ein parallel zum Kondensator (52) verbundener Resonanzzweig (54) modelliert wird, wobei die Referenzkapazität ($C_0$) die Kapazität des Kondensators (52) ist, und
wobei die Referenzkapazität des zusätzlichen piezoelektrischen Elements (76) mindestens dreimal kleiner ist als die Referenzkapazität ($C_0$) des oder der piezoelektrischen Elemente (15) jeder piezoelektrischen Anordnung (12), die zwischen einem jeweiligen ersten (38) und zweiten (48) Mittelpunkt verbunden ist.

10. Wandler (10) nach einem der vorherigen Ansprüche, wobei jede piezoelektrische Anordnung (12) gemäß einer der Ausgestaltungen aus der Gruppe gebildet ist, die aus Folgendem besteht: einem einzigen piezoelektrischen Element (15); mehreren in Reihe verbundenen piezoelektrischen Elementen (15); mehreren parallel verbundenen piezoelektrischen Elementen (15); einem piezoelektrischen Element (15) und einem in Reihe verbundenen Hilfskondensator; einem piezoelektrischen Element (15) und einem parallel verbundenen Hilfskondensator; und einer Anordnung aus mehreren parallelen Zweigen, wobei jeder Zweig ein oder mehrere in Reihe verbundene piezoelektrische Elemente (15) oder einen Hilfskondensator aufweist;
wobei der Hilfskondensator vorzugsweise eine größere Kapazität, vorzugsweise noch mindestens dreimal größer, als eine Referenzkapazität ($C_0$) des oder der piezoelektrischen Elemente (15) aufweist, wobei jedes piezoelektrische Element (15) in Form eines Kondensators (52) und eines parallel zum Kondensator (52) verbundenen Resonanzzweigs (54) modelliert wird, wobei die Referenzkapazität ($C_0$) die Kapazität des Kondensators (52) ist.

11. Elektronisches System (5) zur Stromumwandlung, umfassend einen Stromwandler (10) und eine elektronische Vorrichtung (20) zum Ansteuern des Stromwandlers (10),
**dadurch gekennzeichnet, dass** der Stromwandler (10) gemäß einem der vorherigen Ansprüche ist.

**Claims**

1. An electrical energy converter (10), comprising:

   - a first switching bridge (30) comprising at least one first switching branch (32), each first switching branch (32) being connected between two input voltage ($V_{in}$) application terminals (34) and comprising at least two first switches (36) connected in series and linked together at a first midpoint (38);
   - a second switching bridge (40) comprising at least one second switching branch (42), each second switching branch (42) being connected between two output voltage ($V_{out}$) application terminals (44) and comprising at least two second switches (46) connected in series and linked together at a second midpoint (48);
   - at least one piezoelectric assembly (12), each piezoelectric assembly (12) comprising at least one piezoelectric element (15) and being connected between a respective first midpoint (38) and a respective second midpoint (48);

      **characterized in that** it further comprises at least one switching aid circuit (50), each switching aid circuit (50) being connected to a respective one of the first (38) and second (48) midpoints, each switching aid circuit (50) being configured to, via the flow of a previously received current, discharge at least one parasitic capacitance of a switch (36; 46) of the respective switching bridge (30; 40) to which it is connected, and respectively charge at least one parasitic capacitance of another switch (36; 46) of said switching bridge (30; 40), **in that** the switches (36; 46) of the first (30) and second (40) switching bridges are apt to be commanded to alternate between phases of substantially constant voltage across each piezoelectric assembly (12) and phases of substantially constant load across each piezoelectric assembly (12), the substantially constant voltage being a voltage with a voltage variation of less than 20% of the input or output voltage of the converter (10), the substantially constant load being a load with a load variation of less than 10% of the load which would have been exchanged with the exterior of the piezoelectric assembly(s) (12) if the voltage at the terminals of the piezoelectric assembly(s) (12) had been kept constant over the considered time period, and **in that** the previously received current is obtained in at least one substantially constant voltage phase preceding the discharge of the at least one parasitic capacitance of a switch (36; 46), and respectively the charging of the at least one parasitic capacitance of another switch (36; 46), by the respective switching aid circuit (50).

2. The converter (10) according to claim 1, wherein the switching bridge (30; 40) to which a respective switching aid circuit (50) is connected comprises two switching branches (32; 42), and said switching aid circuit (50) is then connected between the respective midpoints (38; 48) of the two switching branches (32; 42) of said bridge (30; 40).

3. The converter (10) according to claim 2, wherein the first switching bridge (30) comprises two first switching branches (32), and the second switching bridge (40) comprises two second switching branches (42); and the converter (10) comprises two piezoelectric assemblies (12), each being connected between respective first (38) and second (48) midpoints, the midpoints (38, 48) between which the piezoelectric assemblies (12) are connected being distinct from one piezoelectric assembly (12) to another.

4. The converter (10) according to claim 1, wherein the switching bridge (30, 40) to which a respective switching aid circuit (50) is connected comprises a single switching branch (32, 42), and said switching aid circuit (50) is then connected between the midpoint (38, 48) and an end of said switching branch (32; 42) of said bridge (30; 40).

5. The converter (10) according to any one of the preceding claims, wherein the converter (10) comprises two switching aid circuits (50), a first switching aid circuit being connected to the first switching bridge (30) and a second switching aid circuit being connected to the second switching bridge (40).

6. The converter (10) according to any one of the preceding claims, wherein each switching aid circuit (50) is free of a controllable switch, each switching aid circuit (50) being in particular free of a transistor.

7. The converter (10) according to any one of the preceding claims, wherein each switching aid circuit (50) comprises an element selected from the group consisting of: an inductor (70); a first assembly formed of an inductor (70) and a diode (72) connected in series; a second assembly formed of an inductor (70) and a capacitor (74) connected in series; and an additional piezoelectric element (76);
   each switching aid circuit (50) preferably consisting of an element selected from said group.

8. The converter (10) according to any one of the preceding claims, wherein the switching aid circuit (50) comprises an inductor (70) and a diode (72) connected in series, and the diode (72) is oriented according to a direction of flow of the previously received current, the diode (72) being configured to block the flow of a current going from the positive polarity to the negative polarity of a possible direct voltage component of said current.

9. The converter (10) according to any one of the preceding claims, wherein the switching aid circuit (50) comprises an additional piezoelectric element (76), each piezoelectric element (15, 76) has a reference capacitance ($C_0$), each piezoelectric element (15, 76) being modelled as a capacitor (52) and a resonant branch (54) connected in parallel to the capacitor (52), the reference capacitance ($C_0$) being the capacitance of said capacitor (52), and
wherein the reference capacitance of the additional piezoelectric element (76) is at least three times less than the reference capacitance ($C_0$) of the piezoelectric element(s) (15) of each piezoelectric assembly (12) connected between respective first (38) and second (48) midpoints.

10. The converter (10) according to any one of the preceding claims, wherein each piezoelectric assembly (12) is constituted according to one of the group consisting of: a single piezoelectric element (15); a plurality of piezoelectric elements (15) connected in series; a plurality of piezoelectric elements (15) connected in parallel; a piezoelectric element (15) and an auxiliary capacitor connected in series; a piezoelectric element (15) and an auxiliary capacitor connected in parallel; and an arrangement of a plurality of parallel branches, each branch comprising one or more piezoelectric elements (15) connected in series or an auxiliary capacitor;
the auxiliary capacitor having preferably a capacitance greater than a reference capacitance ($C_0$) of the piezoelectric element(s) (15), each piezoelectric element (15) being modelled as a capacitor (52) and a resonant branch (54) connected in parallel to the capacitor (52), the reference capacitance ($C_0$) being the capacitance of said capacitor (52).

11. An electronic system for electrical energy conversion (5) comprising an electrical energy converter (10) and an electronic device (20) for controlling the electrical energy converter (10),
**characterized in that** the electrical energy converter (10) is according to any one of the preceding claims.

FIG.1

EP 4 191 852 B1

FIG.2

FIG.3

FIG.4

**FIG.5**

FIG.6

FIG.7

FIG.8

FIG.9

EP 4 191 852 B1

FIG.10

**RÉFÉRENCES CITÉES DANS LA DESCRIPTION**

**Documents brevets cités dans la description**

- US 2017012556 A1
- US 2013169198 A1
- CN 102522492 A
- FR 3064850 B1
- FR 3086471 A1
- FR 3086472 A1
- FR 2107345

**Littérature non-brevet citée dans la description**

- **BENJAMIN POLLET**. Convertisseurs DC-DC piézoélectrique avec stockage provisoire d'énergie sous forme mécanique. *manuscrit de thèse*
- **MUSTAPHA TOUHAMI et al.** Implementation of control strategy for step-down dc-dc converter based on piezoelectric resonator. *EPE '20 ECCE Europe*, 1-9